# EUROPÄISCHE PATENTSCHRIFT

(11) **EP 3 232 746 B1**
(45) Veröffentlichungstag und Bekanntmachung des Hinweises auf die Patenterteilung: **08.09.2021**
(21) Anmeldenummer: 17166059.0
(22) Anmeldetag: 11.04.2017
(51) Int. Cl.: H05K 1/18, F21S 4/24, F21V 21/005, H05K 1/11

(54) **KONTAKTIERUNG EINES FLEXIBLEN LEITERPLATTENSTREIFENS DURCH EINE KONTAKTIERBRÜCKE**
CONTACTING OF A FLEXIBLE PCB USING A CONTACTING BRIDGE
MISE EN CONTACT D'UNE BANDE SOUPLE DE CIRCUITS IMPRIMÉS PAR UN PONT DE MISE EN CONTACT

(30) Priorität: 12.04.2016 DE 202016101913 U
(43) Veröffentlichungstag der Anmeldung: 18.10.2017
(73) Patentinhaber: Tridonic GmbH & Co. KG, 6850 Dornbirn (AT)
(72) Erfinder: Pachler, Peter, 8042 Graz (AT)
(74) Vertreter: Rupp, Christian

(56) Entgegenhaltungen:
- DE-A1- 10 319 525
- DE-A1-102009 008 095
- US-A1- 2003 112 627

## Beschreibung

### 1. Gebiet der Erfindung

Die vorliegende Erfindung betrifft einen flexiblen Leiterplattenstreifen, der durch eine Kontaktierbrücke elektrisch kontaktierbar ist, ein System umfassend einen solchen flexiblen Leiterplattenstreifen und wenigstens eine Kontaktierbrücke sowie einen Einsatz für eine Leuchte mit einem solchen flexiblen Leiterplattenstreifen.

### 2. Hintergrund

Aus dem Stand der Technik sind flexible Leiterplatten zur Bereitstellung von Leuchtdioden (LEDs) bekannt. Der Vorteil von flexiblen Leiterplatten im Gegensatz zu "normalen" nicht flexiblen (steifen) Leiterplatten ist, dass sie auf uneben Fläche montiert werden können, d.h. die flexible Leiterplatte ist in der Lage sich der Fläche, auf der sie montiert werden soll, anzupassen.

Bei der Montage von flexiblen Leiterplatten mit LEDs durch den Anwender in z.B. Leuchten wird die flexible Leiterplatte auf die gewünschte Länge geschnitten und es werden zur elektrischen Versorgung der LEDs elektrische Verbindungen zwischen den LEDs und z.B. einem Konverter manuell angelötet. D.h. die elektrischen Kontakte auf der Leiterplatte werden zur elektrischen Kontaktierung der LEDs manuell gelötet. Ferner werden zur elektrischen Kontaktierung von einzelnen flexiblen Leiterplatten untereinander elektrische Verbindungen manuell gelötet.

Diese Montage gemäß dem Stand der Technik ist aufgrund dem manuellen Löten aufwendig und zeitintensiv. Insbesondere für Leuchten bzw. Einsatzorte mit ebener Geometrie wäre es daher von Vorteil eine automatische Herstellung von flexiblen Leiterplatten mit LEDs zu haben, die eine verbesserte Montage von flexiblen Leiterplatten mit LEDs ermöglicht.

Bei einer automatischen Bestückung einer flexiblen Leiterplatte mit LEDs durch einen Fertigungsroboter muss die flexible Leiterplatte in Form eines langen flexiblen Leiterplattenstreifens bzw. Leiterplattenbands, vorzugsweise als Rollenware, aus fertigungstechnischen Gründen bereitgestellt werden. Bei einem zu kurzen flexiblen Leiterplattenstreifen (flexiblen Leiterplattenband mit einer zu kurzen Bandlänge) muss der zu bestückende flexible Leiterplattenstreifen in dem Fertigungsroboter oft manuell ausgetauscht werden, was nachteilig ist.

Bei langen flexiblen Leiterplattenstreifen, die aufgrund ihrer Länge für eine automatische Bestückung durch einen Fertigungsroboter geeignet sind, hat sich herausgestellt, dass mit bis zu 10% Ausschuss gerechnet werden muss. D.h. bei einem solchen flexiblen Leiterplattenstreifen ist in der Regel 10% des mit LEDs bestückten flexiblen Leiterplattenstreifens nicht funktionsfähig bzw. defekt. Die Hauptursache hierfür liegt in fehlerhaften Teilbereichen des flexiblen Leiterplattenstreifens, welche fehlerhaft produziert wurden, sowie untergeordnet bei Bestückungsfehlern. Für eine automatisierte Herstellung bzw. Fertigung ohne Reparaturmechanismen sollte jedoch ein flexibler Leiterbahnstreifen von entsprechender Länge vorliegen, welcher in 100% seiner Teilbereiche funktionsfähig ist. Andernfalls müssen entweder Leuchten (aufweisend einen flexiblen Leiterplattenstreifen) repariert oder als Ausschussware aussortiert werden, was beides zu höheren Produktkosten führt.

Im Lichte dieses Standes der Technik ist es daher eine Aufgabe der vorliegenden Erfindung, einen flexiblen Leiterplattenstreifen bereitzustellen, der automatisch durch einen Fertigungsroboter gefertigt bzw. hergestellt werden kann, wobei die Problematik des 10%-Ausschusses behoben werden kann. Ferner ist es eine Aufgabe der vorliegenden Erfindung den flexiblen Leiterplattenstreifen bezüglich einer elektrischen Kontaktierung der LEDs zu verbessern, d.h. eine elektrische Kontaktierung der LEDs auf dem flexiblen Leiterplattenstreifen ohne ein manuelles Löten zu ermöglichen.

Diese und andere Aufgaben, die beim Lesen der folgenden Beschreibung noch genannt werden oder vom Fachmann erkannt werden können, werden durch den Gegenstand der unabhängigen Ansprüche gelöst. Die abhängigen Ansprüche bilden den zentralen Gedanken der vorliegenden Erfindung in besonders vorteilhafter Weise weiter.

### 3. Ausführliche Beschreibung der Erfindung

Gemäß der vorliegenden Erfindung wird ein flexibler Leiterplattenstreifen mit einer LED-Strecke (Leuchtdioden-Strecke) aufweisend elektrisch seriell verbundene LEDs (Leuchtdioden) gemäß des Anspruchs 1 bereitgestellt. Die LED-Strecke weist mehrere LEDs auf, die in einer Reihe in Längserstreckung des flexiblen Leiterplattenstreifens auf dem flexiblen Leiterplattenstreifen angeordnet sind und der flexible Leiterplattenstreifen ist in eine Vielzahl von Abschnitten aufgeteilt, wobei jeder Abschnitt eine vorbestimmten Anzahl an LEDs umfasst. Jeder Abschnitt umfasst ferner wenigstens ein elektrisches Kontaktpaar aufweisend zwei Kontaktierflächen zur elektrischen Kontaktierung der in dem jeweiligen Abschnitt vorhandenen LEDs, wobei die zwei Kontaktierflächen des wenigstens einen Kontaktpaares in dem jeweiligen Abschnitt auf dem flexiblen Leiterplattenstreifen derart angeordnet sind, dass die zwei Kontaktierflächen durch wenigstens eine in Quererstreckung des flexiblen Leiterplattenstreifens quer zu und vorzugsweise über dem flexiblen Leiterplattenstreifen angeordnete Kontaktierbrücke elektrisch kontaktierbar sind.

Mit anderen Worten ist der flexible Leiterplattenstreifen (auch als *flexibles Leiterplattenband"* bezeichnet) und folglich die LEDs auf dem flexiblen Leiterplattenstreifen in mehrere Abschnitt aufgeteilt, wobei jeder Abschnitt zumindest ein elektrisches Kontaktpaar zur elektrischen Kontaktierung der LEDs des jeweiligen Abschnitts aufweist, sodass die LEDs des jeweiligen Abschnitts über das wenigstens eine elektrische Kontaktpaar elektrisch versorgbar sind. Durch diese Eigenschaft wird der flexible Leiterplattenstreifen am Rand jedes Abschnitts teilbar. Das zumindest eine elektrische Kontaktpaar ist derart auf dem flexiblen Leiterplattenstreifen angeordnet, dass die elektrische Kontaktierung durch wenigstens eine Kontaktierbrücke, die in Quererstreckung des flexiblen Leiterplattenstreifens quer zu dem flexiblen Leiterplattenstreifen angeordnet wird, erfolgen kann. Vorzugsweise ist hierbei die Kontaktierbrücke über dem flexiblen Leiterplattenstreifen angeordnet, wobei die Kontaktierbrücke vorzugsweise keine LED abschirmt. Dies ist vorteilhaft, da für eine elektrische Kontaktierung eines Abschnitts des flexiblen Leiterplattenstreifens lediglich eine Kontaktierbrücke bereitgestellt werden muss und folglich ein manuelles Löten nicht mehr benötigt wird. Ferner können die einzelnen Abschnitte über das jeweilige Kontaktpaar einzeln bzw. separat mit elektrischer Energie versorgt werden.

Es kann aufgrund von Spannungsabfällen in den Leitungen des flexiblen Leiterplattenstreifens erforderlich sein mehrere Kontaktierbrücken zu verwenden (in diesem Fall umfasst jeder Abschnitt mehr als ein elektrisches Kontaktpaar) oder eine Einspeisung an gegenüberliegenden Eckpunkten zu gestalten, d.h. die zwei Kontaktierflächen eines Kontaktpaares können bezüglich der in Längserstreckung ausgebildeten Mittenachsen des flexiblen Leiterplattenstreifens gegenüberliegend auf dem flexiblen Leiterplattenstreifen angeordnet sein, wie noch im Weiteren als eine bevorzugte Ausführungsform beschrieben.

Im Folgenden wird ein elektrische Kontaktieren bzw. Betreiben der LEDs eines Abschnitts des flexiblen Leiterplattenstreifens auch als elektrisches Kontaktieren bzw. Betreiben eines Abschnitts des flexiblen Leiterplattenstreifens bezeichnet.

Unter einem *,flexiblen Leiterplattenstreifen"* wird eine im Wesentlichen rechteckige Leiterplatte, vorzugsweise Leiterplattenfolie, verstanden, die aus einem flexiblen Material gebildet ist, sodass sie sich an eine nicht ebene Fläche anpassen kann. Mit anderen Worten ist ein flexibler Leiterplattenstreifen nicht steif, sondern elastisch verformbar, sodass der flexible Leiterplattenstreifen auf einer Rolle aufgerollt und auf eine nicht ebene Fläche, z.B. gekrümmte Fläche, in flächigen Kontakt aufgebracht werden kann. Hierbei muss der flexible Leiterplattenstreifen im Wesentlichen faltenfrei abrollbar und montierbar sein, sodass der flexible Leiterplattenstreifen auf Flächen bzw. Objekten montierbar ist, die in einer Dimension eine im Wesentlichen ebene Linie aufweisen, wie z.B. Zylinder oder Kegel.Flexible Leiterplattenstreifen sind auch als *"Flextapes"* bekannt.

Der flexible Leiterplattenstreifen ist aus elektrisch nicht-leitfähigen Material hergestellt, wobei vorzugsweise Polyimide (z.B. Kapton) eingesetzt werden. Ferner kann auch Polyester verwendet werden. Vorzugsweise weist der flexible Leiterplattenstreifen eine Breite zwischen 10 mm und 50 mm, besonders bevorzugt zwischen 10 mm und 24 mm und ganz bevorzugt zwischen 16 mm und 24 mm und eine Länge von mehr als 30 m auf. Die Länge des flexiblen Leiterbahnstreifens ist durch sein Eigengewicht und der Gefahr der Beschädigung der LEDs durch ein zu hohes Eigengewicht beschränkt. Eine Länge zwischen 100 m und 200 m ist als besonders bevorzugt anzusehen.

Im Folgenden wird mit dem Begriff *"LED"* bzw. *"Leuchtdiode"* insbesondere eine Leuchtdiode der Leuchtdioden-Strecke bezeichnet. Der flexible Leiterplattenstreifen kann noch weitere LEDs aufweisen, die nicht Bestandteil der LED-Strecke sind. Zum Beispiel können weitere LEDs, vorzugsweise 10% aller LEDs auf dem flexiblen Leiterplattenstreifen, für ein Notlicht vorgesehen sein.

Unter einer *"LED"* bzw. *"Leuchtdiode"* versteht man jedes Halbleiterbauelement, das dazu angepasst ist, elektromagnetische Wellen, insbesondere elektromagnetische Wellen in dem für das menschliche Auge sichtbaren Bereich, zu emittieren, wie z.B. anorganische oder organische Leuchtdioden, Leuchtdioden mit oder ohne einer Sekundäranregung durch einen Leuchtstoff usw.

Unter *"LEDs, die in einer Reihe in Längserstreckung des flexible Leiterplattenstreifens angeordnet sind"* versteht man, dass bis auf die zwei LEDs an den beiden Enden der Reihe, jede LED entlang der Längserstreckung des flexible Leiterplattenstreifens eine in der Reihe vorausgehende und eine in der Reihe nachfolgende LED hat, d.h. benachbart zu zwei Leuchtdioden ist. Vorzugsweise sind die LEDs gleichmäßig beabstandet bzw. äquidistant (zueinander) angeordnet, d.h. der Abstand zwischen zwei benachbarten LEDs ist für alle LEDs derselbe. Hierbei ist vorzugsweise sowohl der Abstand zwischen zwei benachbarten LEDs desselben Abschnitts wie auch der Abstand zwischen zwei benachbarten LEDs zweier unterschiedlicher Abschnitte derselbe.

Unter der *"Längserstreckung des flexiblen Leiterplattenstreifens"* versteht man die Richtung entlang der Längsachse des im Wesentlichen rechteckigen flexiblen Leiterplattenstreifens.

Unter der *"Quererstreckung des flexiblen Leiterplattenstreifens"* versteht man die Richtung entlang der Querachse/Breitenachse des im Wesentlichen rechteckigen Leiterplattenstreifens bzw. die Richtung entlang der Achse, die orthogonal zu der Längsachse des im Wesentlichen rechteckigen flexiblen Leiterplattenstreifens ist.

Die Abschnitte des flexiblen Leiterplattenstreifens sind vorzugsweise zwischen 50 mm und 2500 mm, besonders bevorzugt zwischen 100 mm und 250 mm, ganz besonders bevorzugt 140 mm, lang. Vorzugsweise sind die Abschnitte gleich lang und umfassen die gleiche Anzahl an LEDs. Die LEDs eines Abschnitts sind vorzugsweise seriell miteinander elektrisch verbunden. Vorzugsweise können in einem Abschnitt auch mehrere Serienschaltungen von LEDs parallel elektrisch verschaltet werden, wie noch im Weiteren als eine bevorzugte Ausführungsform beschrieben.

Vorzugsweise weist ein Abschnitt zwischen 6 und 18 LEDs, besonders bevorzugt zwischen 6 und 16 LEDs, ganz besonders bevorzugt 11 LEDs auf. Vorzugsweise sind in einem Abschnitt die LEDs derart seriell elektrisch verschaltet, dass die resultierende Durchflussspannung der seriellen Verschaltung der LEDs die Schutzspannung von 60V (SELV) nicht überschreitet, da ansonsten weitere Sicherheitsmaßnahmen (Isolierung) erforderlich sind.

Eine möglichst kurze Länge der Abschnitte des flexiblen Leiterbahnstreifens ist vorteilhaft, um eine möglichst flexible Anpassung des flexiblen Leiterplattenstreifens an verschiedene Längen zu ermöglichen. Vorzugsweise kann die Länge der Abschnitte des flexiblen Leitertplattenstreifens auch (unabhängig von einer späteren Anpassung des flexiblen Leiterplattenstreifens an verschiedene Längen) derart gewählt sein, dass die Länge der Abschnitte des flexiblen Leiterplattenstreifens bereits der gewünschte Länge im Produkt entspricht, um dadurch eine optimale Ausnutzung der Anzahl von LEDs zu ermöglichen.

Werden z.B. Leuchten mit einer 2 m Länge gefertigt, so entspricht die Länge der Abschnitte des flexiblen Leiterplattenstreifens vorzugsweise 10 cm, 20cm oder 25 cm, wobei dann entsprechend 20, 10 oder 8 Abschnitte des flexiblen Leiterplattenstreifens in einer solchen Leuchte montierbar sind.

Ein flexibler Leiterplattenstreifen, dessen Abschnitte bezüglich ihrer Länge auf die gewünschte Länge im Produkt angepasst sind, ist vorteilhaft, da eine optimale Anzahl an LEDs in jedem Abschnitt angeordnet werden kann. Unter einer optimalen Anzahl an LEDs in einem Abschnitt des flexiblen Leiterplattenstreifens versteht man eine Anzahl an LEDs, bei der einerseits die Schutzspannung von 60V (SELV) nicht überschritten wird und anderseits nicht zu wenige LEDs in dem Abschnitt des flexiblen Leiterplattenstreifens angeordnet sind, was andernfalls zu einem hohem Strom in den elektrischen Kontakten, hohen Leitungsverlusten und/oder zu einer ungünstigen bzw. asymmetrischen Stromverteilung im Abschnitt führen könnte. Bei der anderen oben beschriebenen Variante ist eine optimale Anzahl von LEDs in den ausgeführten Grenzen eher nicht erreichbar, weswegen stets eine etwas höhere Anzahl von LEDs eingesetzt werden muss, was zu etwas höheren Produktionskosten führt. Diese Variante bezüglich der Länge der Abschnitte des flexiblen Leitertplattenstreifens bietet aber bei der Montage eine höhere Flexibilität.

Unter einem *"elektrischen Kontaktpaar aufweisend zwei Kontaktierflächen"* wird ein elektrischer Anschluss eines Abschnitts verstanden, über den eine elektrische Spannung bzw. ein elektrischer Strom zum Betreiben der LEDs des Abschnitts zugeführt werden kann. Die Kontaktierflächen sind aus einem leitenden Material, wie z.B. Kupfer. Vorzugsweise werden für die Kontaktierflächen vergoldete Kontakte verwendet. Wird zum Beispiel eine Spannung an einem elektrischen Kontaktpaar angelegt, dann bildet eine der beiden Kontaktflächen des Kontaktpaares den Pluspol und die andere der beiden Kontaktflächen den Minuspol. Vorzugsweise weist jeder Abschnitt die gleiche Anzahl an Kontaktpaaren auf. Eine Kontaktierfläche kann auch als Einfachkontakt bezeichnet werden.

Jeder Abschnitt weist ein elektrisches Kontaktpaar auf, insbesondere wenn die Abschnitte des flexiblen Leiterplattenstreifens eine kurze Länge aufweisen. Für den Fall, dass die Abschnitte des Leiterplattenstreifens sehr lang sind, weist jeder Abschnitt vorzugsweise zumindest eine Kontaktierbrücke auf, die bereits mit den Kontaktierflächen des zumindest einen elektrischen Kontaktpaares elektrisch verbunden, vorzugsweise verlötet, ist. Mit anderen Worten kann bei einem flexiblen Leitertplattenstreifens, der in sehr lange Abschnitten aufgeteilt ist, in jedem Abschnitt auf das zumindest eine elektrische Kontaktpaar verzichtet werden und jeder Abschnitte ist bereits mit zumindest einer Kontaktierbrücke zum elektrischen Kontaktieren der LEDs des jeweiligen Abschnitts elektrisch verbunden. In einem solchen Fall entspricht die Länge der sehr langen Abschnitte des flexiblen Leiterplattenstreifens vorzugsweise der Länge der Leuchte, in der der flexible Leiterplattenstreifen bzw. ein Abschnitt des flexiblen Leiterplattenstreifens montiert werden soll. Alternativ oder zusätzlich ist die Länge der sehr langen Abschnitte des flexiblen Leiterplattenstreifens vorzugsweise derart, dass die LEDs jedes Abschnitts durch einen Konverter versorgbar sind (dies musst dann bei der Montage beachtet werden).

Unter *"einer Anordnung der Kontaktierbrücke in Quererstreckung des flexiblen Leiterplattenstreifens quer zu dem flexiblen Leiterplattenstreifen"* wird verstanden, dass die Kontaktierbrücke derart angeordnet ist, dass die Längsachse der Kontaktierbrücke im Wesentlich parallel bzw. in Richtung der Querachse des flexiblen Leiterplattenstreifens angeordnet ist.

Gemäß einer bevorzugten Ausführungsform des erfindungsgemäßen flexiblen Leiterplattenstreifens ist der flexible Leiterplattenstreifen vorzugsweise durch eine in Längserstreckung gebildete Mittenachse in einen ersten und zweiten Bereich aufgeteilt, wobei in jedem Abschnitt das wenigsten eine elektrische Kontaktpaar vorzugsweise in dem ersten oder zweiten Bereich angeordnet ist.

Mit anderen Worten ist das wenigstens eine Kontaktpaar oberhalb der in Längserstreckung ausgebildeten Mittenachse oder unterhalb der in Längserstreckung ausgebildeten Mittenachse angeordnet. Unter einer "in *Längserstreckung ausgebildeten Mittenachse"* versteht man die in Längserstreckung des flexiblen Leiterplattenstreifens ausgebildete Mittenachse des flexiblen Leiterplattenstreifens. Vorzugsweise stellt die in Längserstreckung ausgebildete Mittenachse im Wesentlichen eine in Längserstreckung ausgebildete Symmetrieachse des flexiblen Leiterplattenstreifens dar. Für den Fall, dass in jedem Abschnitt mehr als ein elektrisches Kontaktpaar, z.B. zwei elektrische Kontaktpaare, angeordnet sind, ist vorzugsweise ein elektrisches Kontaktpaar oberhalb (erster Bereich) der in Längserstreckung ausgebildeten Mittenachse und das andere elektrische Kontaktpaar unterhalb (zweiter Bereich) der in Längserstreckung ausgebildeten Mittenachse angeordnet. Alternativ sind vorzugsweise beide elektrischen Kontaktpaare oberhalb (erster Bereich) oder unterhalb (zweiter Bereich) der in Längserstreckung ausgebildeten Mittenachse angeordnet.

Folglich kann jeder Abschnitt durch eine Kontaktierbrücke elektrisch kontaktiert werden, die ihre Kontaktiereinheiten in eine Richtung wegführt, wodurch eine günstigere und schnelle Kontaktierung ermöglicht wird.

Gemäß einer weiteren bevorzugten Ausführungsform des erfindungsgemäßen flexiblen Leiterplattenstreifens ist der flexible Leiterplattenstreifen vorzugsweise durch eine in Längserstreckung gebildete Mittenachse in einen ersten und zweiten Bereich aufgeteilt, wobei vorzugsweise in jedem Abschnitt eine erste Kontaktierfläche der zwei Kontaktierflächen des wenigstens einen elektrischen Kontaktpaares in dem ersten Bereich und eine zweite Kontaktierfläche der zwei Kontaktierflächen des wenigstens einen elektrischen Kontaktpaares in dem zweiten Bereich derart angeordnet sind, dass die erste Kontaktierfläche und die zweite Kontaktierfläche des wenigstens einen elektrischen Kontaktpaares gegenüberliegend auf dem flexiblen Leiterplattenstreifen angeordnet sind.

Mit anderen Worten sind die zwei Kontaktierfläche eines elektrischen Kontaktpaares derart bezüglich der in Längserstreckung ausgebildeten Mittenachse gegenüberliegend auf dem flexiblen Leiterplattenstreifen angeordnet, dass eine Kontaktierfläche des elektrischen Kontaktpaares oberhalb (erster Bereich) und die andere Kontaktierfläche des elektrischen Kontaktpaares unterhalb (zweiter Bereich) der in Längserstreckung ausgebildeten Mittenachse angeordnet sind.

Ferner sind vorzugsweise in jedem Abschnitt die zwei Kontaktierflächen des wenigstens einen elektrischen Kontaktpaares in einem Innenbereich des jeweiligen Abschnitts bezüglich der Längserstreckung und/oder Quererstreckung des flexiblen Leiterplattenstreifens angeordnet. Vorzugsweise sind die LEDs in dem Innenbereich bezüglich der Längserstreckung und/oder Quererstreckung des flexiblen Leiterplattenstreifens, besonders bevorzugt entlang der in Längsrichtung ausgebildeten Mittenachse angeordnet.

Ein ausgebildeter Randbereich auf dem flexiblen Leiterplattenstreifen ist in Längserstreckung des elektrischen Leiterplattenstreifens ausgebildet, der frei von elektrischen Kontaktpaaren und/oder LEDs ist. Folglich kann dieser Randbereich zum Beispiel für eine Montage des flexiblen Leiterplattenstreifens auf einen Träger zum Andrücken des flexiblen Leiterplattenstreifens auf den Träger dienen.

Des Weiteren weist jeder Abschnitt in Längserstreckung des flexiblen Leiterplattenstreifens zwei Randbereiche auf, die in Längserstreckung des flexiblen Leiterplattenstreifens auf gegenüberliegenden Seiten des in Längserstreckung des flexiblen Leiterplattenstreifens ausgebildeten Innenbereichs des jeweiligen Abschnitts liegen, wobei jeder Randbereich wenigstens eine Verbindungsfläche aufweist, die derart in dem jeweiligen Randbereich auf dem flexiblen Leiterplattenstreifen angeordnet ist, dass die Verbindungsfläche eines Randbereichs eines Abschnitts des flexiblen Leiterplattenstreifens mit der Verbindungsfläche eines Randbereichs eines anderen Abschnitts des flexiblen Leiterplattenstreifens durch eine Kontaktierungsleiterplatte elektrisch verbindbar ist.

Mit anderen Worten umfasst jeder Abschnitt des flexiblen Leiterplattenstreifens an den beiden Enden der Längserstreckung wenigstens eine Verbindungsfläche, die dazu dient den jeweiligen Abschnitt mit einem anderen Abschnitt des flexiblen Leiterplattenstreifens elektrisch zu verbinden. Hierbei wird eine Verbindungsfläche des einen Abschnitts mit einer Verbindungsfläche des anderen Abschnitts durch eine Kontaktierungsleiterplatte elektrisch verbunden.

Unter einer *"Kontaktierungsleiterplatte"* wird ein elektrische Adapter verstanden, der dazu eingerichtet ist einen Abschnitt des flexiblen Leiterplattenstreifens mit eine anderem Abschnitt des flexiblen Leiterplattenstreifens elektrisch zu verbinden, indem die Kontaktierungsleiterplatte mit einer Verbindungsfläche des einen Abschnitts und mit einer Verbindungsfläche des anderen Abschnitts elektrisch verbunden bzw. kontaktiert wird. Die Kontaktierungsleiterplatte wird dazu mit den beiden Abschnitten des Leiterplattenstreifens, welche vorzugsweise jeweils einen separaten flexiblen Leiterplattenstreifen darstellen, verlötet und bildet sowohl einen mechanischen als auch elektrischen Kontakt aus.

Die ist vorteilhaft, da hierdurch zwei voneinander getrennte Abschnitte des erfindungsgemäßen Leiterplattenstreifens durch die Kontaktierungsleiterplatte miteinander elektrisch verbunden werden können. Folglich kann aus einer Vielzahl einzelner Abschnitte ein flexibler Leiterplattenstreifen gebildet werden.

Bei der Fertigung bzw. Herstellung eines flexiblen Leiterplattenstreifens aufweisend LEDs gibt es zwei Möglichkeiten: Entweder wird von einem vorzugsweise zu einer Rolle aufgerollten langen flexiblen Leiterplattenstreifen ausgegangen, der eine für eine automatische Fertigung geeignet Länge aufweist und in Abschnitte aufgeteilt ist; oder es wird von einem getrennten bzw. aufgeschnittenen flexiblen Leiterplattenstreifen, d.h. einzelnen voneinander getrennten Abschnitten eines flexiblen Leitertplattenstreifens, die selber jeweils einen flexible Leiterplattenstreifen darstellen und auch als *"Sheets"* bezeichnet werden, ausgegangen. Wie bereits vorgehend beschrieben können bei langen flexiblen Leiterplattenstreifen, insbesondere bei flexiblen Leiterplattenstreifen mit einer für eine automatische Fertigung geeigneten Länge, einzelne Abschnitte defekt sein (in der Regel ist 10% eines flexiblen Leiterplattenstreifens, dessen Länge für eine automatische Fertigung geeignet ist, defekt). Um einen flexiblen Leiterplattenstreifen mit defekten Abschnitten zu reparieren, werden die defekten bzw. nicht funktionsfähigen Abschnitte vorzugsweise herausgeschnitten bzw. entfernt und die übrig bleibenden "guten" bzw. funktionsfähigen Abschnitte des flexiblen Leiterplattenstreifens werden mit Hilfe von Kontaktierungsleiterplatten wieder verbunden.

Ferner ist vorzugsweise jeder Abschnitt dazu eingerichtet, derart aus dem flexiblen Leiterplattenstreifen entfernbar zu sein, dass die LEDs des jeweiligen Abschnitts elektrisch betreibbar sind.

Vorzugsweise weist jeder Abschnitt wenigstens zwei Unterabschnitte auf, die parallel miteinander elektrisch verbunden sind, wobei jeder Unterabschnitt eine vorbestimmte Anzahl an LEDs, vorzugsweise elf LEDs, aufweist, die miteinander seriell elektrisch verbunden sind.

Je mehr LEDs seriell miteinander elektrisch verbunden sind, desto größer wird die sich ergebende kombinierte Durchflussspannung der Serienschaltung von LEDs. Folglich kann in jedem Abschnitt durch eine Parallelschaltung von Unterabschnitten von Serienschaltungen von LEDs die sich ergebende kombinierte Durchflussspannung begrenzt werden.

Des Weiteren ist vorzugsweise die vorbestimmte Anzahl an LEDs eines jeweiligen Unterabschnitts derart, dass die durch die Anzahl an LEDs verursachte Durchflussspannung einer SELV-Spannung entspricht.

Dies ist vorteilhaft, da eine geringere elektrische Isolation des flexiblen Leiterplattenstreifens vorgesehen sein muss, wenn die sich ergebende kombinierte Durchflussspannung der einzelnen Unterabschnitte einer SELV-Spannung entspricht.

Unter *"SELV-Spannung"* versteht man eine Sicherheitskleinspannung bzw. Schutzkleinspannung ("*SELV" = "Safety Extra Low Voltage").* Nach Norm darf diese Schutzkleinspannung 60V nicht überschreiten, da dann noch keine zusätzliche Isolationsvorkehrungen erforderlich sind. Somit ist die vorbestimmte Anzahl an LEDs eines jeweiligen Unterabschnitts vorzugsweise derart, dass die durch die Anzahl an LEDs verursachte Durchflussspannung kleiner gleich 60V ist, d.h. einen Spannungswert von 60V nicht überschreitet. Aufgrund von Toleranzen bei den LEDs und Leitungsabfällen sowie der endlichen Fähigkeit von Konvertern eine Spannung schnell genug einzuregeln, ist die vorbestimmte Anzahl an LEDs eines jeweiligen Unterabschnitts besonders vorzugsweise derart, dass die durch die Anzahl an LEDs verursachte Durchflussspannung kleiner gleich 48 V ist.

Ferner weist vorzugsweise jeder Abschnitt eine vorbestimmte Anzahl an Unterabschnitten auf (welche zueinander parallel geschaltet sind); wobei die vorbestimmte Anzahl an Unterabschnitten vorzugsweise derart ist, dass der zum Betreiben der vorbestimmten Anzahl an Unterabschnitten benötigte Strom kleiner als ein vorbestimmter Strom ist, wobei der vorbestimmte Strom vorzugsweise zwischen 14 mA und 500 mA, besonders vorzugsweise zwischen 60 mA und 180 mA, ist.

Der jedem Abschnitt zugeführte Strom ist derart eingestellt, dass vorzugsweise ein Lichtstrom von 2500 lm/m bis 7000 lm/m erreicht wird, welcher für Allgemeinbeleuchtungen üblich ist (lm/m = *"Lumen pro Meter").* Zum Beispiel um einen Lichtstrom von 1000 lm/m zu erreichen, welcher als untere Grenze für Beleuchtungsanwendungen dient, muss bei
- einer Länge jedes Abschnitts des flexiblen Leitertplattenstreifens von 10 cm,
- einer an jedem Abschnitt, insbesondere an den LEDs jedes Abschnitts, abfallenden Spannung von 48 V (dies ist z.B. der Fall wenn jeder Abschnitt zwei parallel verbundene Unterabschnitte aufweist, wobei jeder Unterabschnitt 8 in Serie geschaltete LEDs aufweist), sowie
- einer Lichtausbeute von 150 lm/W der einzelnen LEDs
   ein Strom von 14 mA jedem Abschnitt zugeführt werden, d.h. ein Strom von 14 mA/10cm muss bereitgestellt werden. Dies entspricht dann einem Strom von 140 mA/m. Mit einem Strom von 140 mA/m und einer Spannung von 48 V ergibt sich dann bei einer Lichtausbeute von 150 lm/W der einzelnen LEDs ein Lichtstrom von etwa 1000 lm/m (48 V × 140 mA/m × 150 lm/W = 1008 lm/m). Um zum Beispiel einen Lichtstrom von 10000 lm/m zu erreichen, welcher als obere Grenze für Beleuchtungsanwendungen dient, muss bei
- einer Länge jedes Abschnitts des flexiblen Leitertplattenstreifens von 15 cm,
- einer an jedem Abschnitt, insbesondere an den LEDs jedes Abschnitts, abfallenden Spannung von 24 V (dies ist z.B. der Fall wenn jeder Abschnitt 6 in Serie geschaltete LEDs aufweist), sowie
- einer Lichtausbeute von 120 lm/W der einzelnen LEDs
ein Strom von 520 mA jedem Abschnitt zugeführt werden, d.h. ein Strom von 520 mA/15cm muss bereitgestellt werden. Dies entspricht dann einem Strom von 3,47 A/m. Mit einem Strom von 3,47 A/m und einer Spannung von 24 V ergibt sich dann bei einer Lichtausbeute von 120 lm/W der einzelnen LEDs ein Lichtstrom von etwa 10000 lm/m (24 V × 3,47 A/m × 120 lm/W = 9993,6 lm/m).

Gemäß der vorliegenden Erfindung wird ferner ein System gemäß des Anspruchs 9 bereitgestellt, das einen vorstehend beschriebenen erfindungsgemäßen flexiblen Leiterplattenstreifen und wenigstens eine Kontaktierbrücke umfasst. Die wenigstens eine Kontaktierbrücke weist wenigstens eine Kontaktiereinheit auf und ist dazu eingerichtet, durch Anordnung in Quererstreckung des flexiblen Leiterplattenstreifens quer zu und über dem flexiblen Leiterplattenstreifen wenigstens eine Kontaktierfläche eines Abschnitts des flexiblen Leiterplattenstreifens durch die wenigstens eine Kontaktiereinheit elektrisch zu kontaktieren.

Dies ist vorteilhaft, da durch die Positionierung bzw. Anordnung der Kontaktierbrücke wenigstens eine Kontaktierfläche eines Abschnitts des flexiblen Leiterplattenstreifens durch die wenigstens eine Kontaktiereinheit elektrisch kontaktiert werden kann, ohne dass ein manuelles Löten benötigt wird. Vorzugsweise werden die Kontaktierbrücken zur elektrischen Kontaktierung der Abschnitte des flexiblen Leiterplattenstreifens durch einen Fertigungsroboter automatisch angeordnet.

Vorzugsweise entspricht die wenigstens eine Kontaktiereinheit einem elektrischen Federkontakt.

Ferner weist die Kontaktierbrücke vorzugsweise zwei Kontaktiereinheiten auf und ist vorzugsweise dazu eingerichtet, durch die zwei Kontaktiereinheiten zwei Kontaktierflächen eines elektrischen Kontaktpaares eines Abschnitts des flexiblen Leiterplattenstreifens elektrisch zu kontaktieren.

Des Weiteren ist der flexible Leiterplattenstreifen vorzugsweise durch eine in Längserstreckung gebildete Mittenachse in einen ersten und zweiten Bereich aufgeteilt ist und die zwei Kontaktiereinheiten der Kontaktierbrücke sind vorzugsweise in Längserstreckung der Kontaktierbrücke auf der Kontaktierbrücke derart gegenüberliegend angeordnet, dass die Kontaktierbrücke dazu eingerichtet ist, zwei Kontaktierflächen eines elektrischen Kontaktpaares eines Abschnitts des flexiblen Leiterplattenstreifens durch die zwei Kontaktiereinheiten elektrisch zu kontaktieren, wobei eine erste Kontaktierfläche der wenigsten zwei Kontaktierflächen des elektrischen Kontaktpaares in dem ersten Bereich und eine zweite Kontaktierfläche der wenigsten zwei Kontaktierflächen des elektrischen Kontaktpaares in dem zweiten Bereich des flexiblen Leiterplattenstreifens gegenüberliegend angeordnet sind.

Des Weiteren wird gemäß der vorliegenden Erfindung ein Einsatz für eine Leuchte bereitgestellt, der wenigstens einen Abschnitt des vorstehenden beschriebenen erfindungsgemäßen flexiblen Leiterplattenstreifens, wenigstens eine vorstehenden beschriebene erfindungsgemäße Kontaktierbrücke und eine Trägerplatte umfasst. Der wenigstens eine Abschnitt ist auf der Trägerplatte montiert und die zwei Kontaktierflächen des wenigstens einen elektrischen Kontaktpaares des wenigstens einen Abschnitts sind durch die wenigstens eine Kontaktierbrücke elektrisch kontaktiert.

Dies ist vorteilhaft, da hierdurch die LEDs eines Abschnitts des flexiblen Leiterplattenstreifens ohne ein manuelles Löten in einer Leuchte elektrisch verbunden bzw. elektrisch kontaktiert werden können.

Vorzugsweise ist die Trägerplatte aus Metall, besonders vorzugsweise aus Aluminium ist, und stellt einen Kühlkörper dar. Es kann jedoch auch Stahlblech verwendet werden, wenn die LEDs bezüglich des geforderten Lampenlichtstroms bzw. Leuchtenlichtstroms ausreichend durch das Stahlblech gekühlt wird.

Ferner ist der wenigstens eine Abschnitt des flexiblen Leiterplattenstreifens vorzugsweise durch eine Klebverbindung, besonders vorzugsweise Klebeband oder Flüssigkleber, auf der Trägerplatte montiert.

Vorzugsweise weist der (zu einer Rolle aufgerollte) flexible Leiterplattenstreifen das Klebeband bereits auf, wobei bei der Montage des flexiblen Leiterplattenstreifens die Schutzfolie des Klebebands in geeigneter Weise entfernt wird, sodass eine Klebeverbindung zwischen dem Klebeband des flexible Leiterplattenstreifens und der Fläche (z.B. die Trägerplatte) hergestellt werden kann, auf der der flexible Leitertplattenstreifens montiert werden soll. Vorzugsweise ist das Klebeband auf der der Lichtabgabeseite des flexiblen Leiterplattenstreifens gegenüberliegenden Seite angebracht, wobei die LEDs auf der Lichtabgabeseite des flexiblen Leitertplattenstreifens angeordnet sind.

### Beschreibung bevorzugter Ausführungsformen

Nachfolgend wird anhand einer detaillierten Beschreibung der Figuren die Erfindung bzw. weitere bevorzugte Ausführungsformen und Vorteile der Erfindung näher erläutert, wobei die Figuren lediglich bevorzugte Ausführungsformen der Erfindung beschreiben. Gleiche Bestandteile in den Figuren werden mit gleichen Bezugszeichen versehen. Die Figuren sind nicht als maßstabsgetreu anzusehen, es können einzelne Elemente der Figuren übertrieben groß bzw. übertrieben vereinfacht dargestellt sein. Im Einzelnen zeigt
**Figur 1** eine schematische Draufsicht auf eine bevorzugte Ausführungsform eines erfindungsgemäßen flexiblen Leiterplattenstreifens sowie eine vergrößerte schematische Draufsicht auf einen Abschnitt dieser bevorzugten Ausführungsform eines erfindungsgemäßen flexiblen Leiterplattenstreifens.
**Figur 2** zwei schematische Draufsichten auf einen Abschnitt einer bevorzugten Ausführungsform eines erfindungsgemäßen flexiblen Leiterplattenstreifens, wobei sowohl die in Längserstreckung des flexiblen Leiterplattenstreifens ausgebildeten Randbereiche und Innenbereich (oben) wie auch die in Quererstreckung des flexiblen Leiterplattenstreifens ausgebildeten Randbereiche und Innenbereich (unten) gezeigt sind.
**Figur 3** eine schematische Draufsicht auf einen Abschnitt einer bevorzugten Ausführungsform eines erfindungsgemäßen flexiblen Leiterplattenstreifens sowie schematische Draufsichten auf eine bevorzugte Ausführungsform einer erfindungsgemäßen Kontaktierbrücke zur elektrischen Kontaktierung des elektrischen Leiterplattenstreifens.
**Figur 4** eine schematische Draufsicht auf einen Abschnitt einer bevorzugten Ausführungsform eines erfindungsgemäßen flexiblen Leiterplattenstreifens sowie schematische Draufsichten auf eine weitere bevorzugte Ausführungsform einer erfindungsgemäßen Kontaktierbrücke zur elektrischen Kontaktierung des elektrischen Leiterplattenstreifens.
**Figur 5** eine schematische Draufsicht auf eine bevorzugte Ausführungsform eines erfindungsgemäßen flexiblen Leiterplattenstreifens sowie einen schematischen Schaltplan einer bevorzugte Ausführungsform einer elektrischen Verschaltung der LEDs auf dem flexiblen Leiterplattenstreifen.
**Figur 6** eine schematische Draufsicht auf einen Abschnitt einer weiteren bevorzugte Ausführungsform eines erfindungsgemäßen flexiblen Leiterplattenstreifens sowie einen schematischen Schaltplan einer bevorzugte Ausführungsform einer elektrischen Verschaltung der LEDs in dem Abschnitt auf dem flexiblen Leiterplattenstreifen.
**Figur 7** eine schematische Draufsicht auf zwei Abschnitte einer bevorzugte Ausführungsform eines erfindungsgemäßen flexiblen Leiterplattenstreifens, die durch eine Kontaktierungsleiterplatte miteinander elektrisch verbunden sind.
**Figur 8** eine bevorzugte Ausführungsform eines erfindungsgemäßen Verfahren zur Herstellung eines erfindungsgemäßen flexiblen Leiterplattenstreifens ohne defekte Abschnitte.
**Figur 9** eine schematische Seitenansicht auf eine bevorzugte Ausführungsform einer erfindungsgemäßen Leuchte aufweisend den erfindungsgemäßen flexiblen Leiterplattenstreifen.

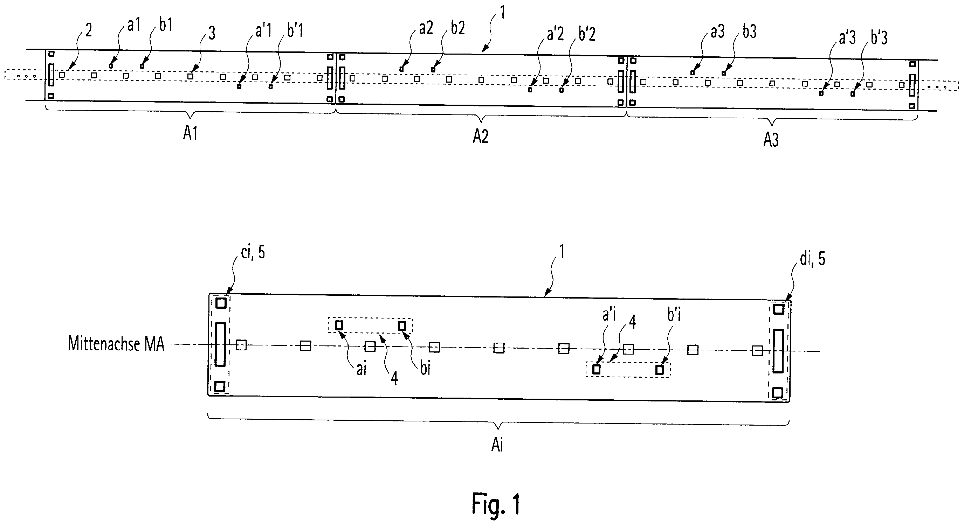

Figur 1 zeigt eine schematische Draufsicht auf eine bevorzugte Ausführungsform eines erfindungsgemäßen flexiblen Leiterplattenstreifens sowie eine vergrößerte schematische Draufsicht auf einen Abschnitt dieser bevorzugten Ausführungsform eines erfindungsgemäßen flexiblen Leiterplattenstreifens.

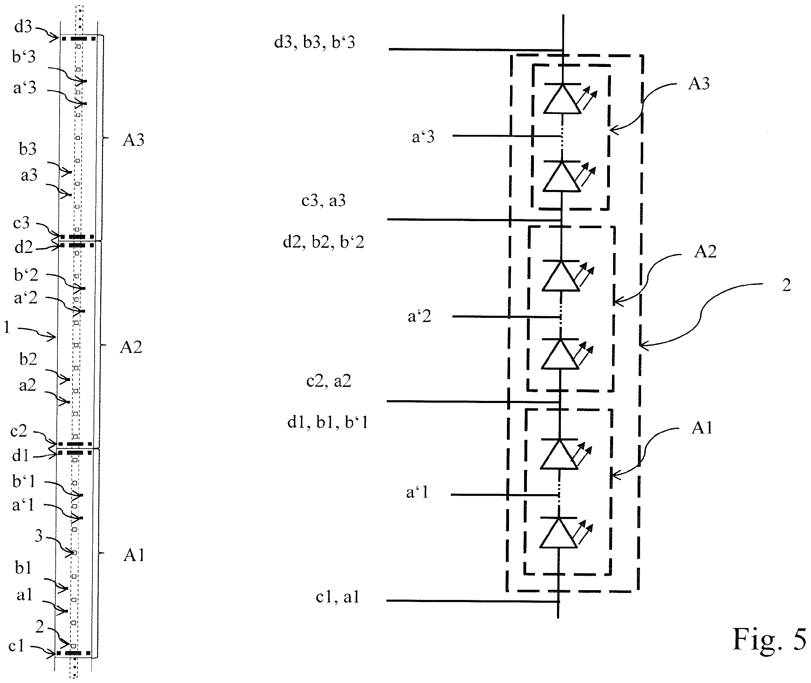

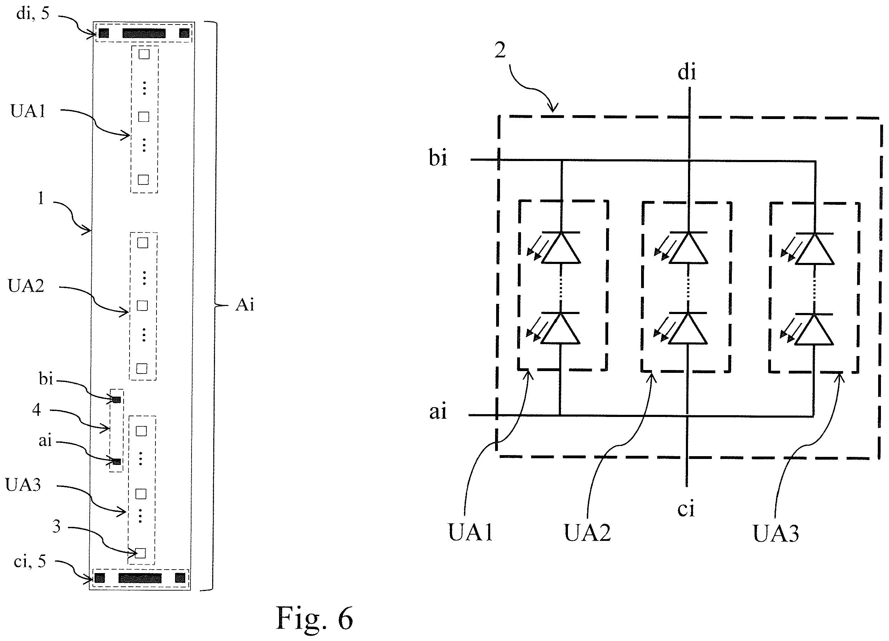

Der flexible Leiterplattenstreifen 1 umfasst eine Vielzahl von Abschnitten Ai, wobei in Figur 1 drei Abschnitte A1, A2 und A3 gezeigt sind. Die LEDs 3 des flexiblen Leiterplattenstreifens bzw. der einzelnen Abschnitte Ai des flexiblen Leiterplattenstreifens bilden eine LED-Strecke 2. Gemäß der Figur 1 umfassen die Abschnitte A1, A2, A3 jeweils neun LEDs 3. Die Abschnitte des flexiblen Leiterplattenstreifens 1 können aber auch weniger oder mehr LEDs 3 umfassen. Vorzugsweise umfassen die Abschnitte jeweils gleich viele LEDs 3. Die elektrische Verschaltung der LEDs 3 eines Abschnitts wird bezüglich der Figuren 5 und 6 näher beschrieben.

Die LEDs 3 sind vorzugsweise entlang der in Längserstreckung bzw. Längsrichtung ausgebildeten Mittenachse MA des flexiblen Leiterplattenstreifens 1 mittig auf dem flexiblen Leiterplattenstreifen 1 angeordnet. Hierbei sind die LEDs 3 in einer Reihe auf dem flexiblen Leiterplattenstreifen angeordnet. Die in Längserstreckung ausgebildete Mittenachse MA bildet hierbei vorzugsweise im Wesentlichen die in Längserstreckung ausgebildete Symmetrieachse des flexiblen Leiterplattenstreifens 1.

Die Abschnitte A1, A2 und A3 weisen jeweils zwei elektrische Kontaktpaare 4 zur elektrischen Kontaktierung der in dem jeweiligen Abschnitt angeordneten LEDs 3 auf. Die Abschnitte A1, A2 und A3 des flexiblen Leiterplattenstreifens 1 könne aber jeweils auch nur ein elektrisches Kontaktpaar 4 oder mehr als zwei elektrische Kontaktpaare 4 aufweisen.

Im Folgenden wird die Beschreibung der Abschnitte A1, A2 und A3 an Hand des vergrößerten Abschnitts Ai durchgeführt, wobei der Abschnitt Ai exemplarisch für einen der Abschnitte, wie z.B. die Abschnitte A1, A2 und A3, des flexiblen Leiterplattenstreifens 1 steht. Vorzugsweise sind die einzelnen Abschnitte Ai des flexiblen Leiterplattenstreifens 1 gleich bezüglich der Anzahl an LEDs 3, elektrischen Kontaktpaaren 4 und Verbindungsflächen 5 sowie der Anordnung und elektrischen Verschaltung dieser Elemente auf dem flexiblen Leiterplattenstreifen 1.

Wie in der Figur 1 gezeigt, teilt die in Längserstreckung ausgebildete Mittenachse MA des flexiblen Leiterplattenstreifens 1 den Abschnitt in einen ersten Bereich bzw. oberen Bereich sowie in einen zweiten Bereich bzw. unteren Bereich. In dem ersten Bereich ist das elektrische Kontaktpaar 4 aufweisend die beiden Kontaktierflächen ai und bi und in dem zweiten Bereich ist das elektrische Kontaktpaar 4 aufweisend die beiden Kontaktierflächen a'i und b'i angeordnet. D.h. jeder Abschnitt Ai des flexiblen Leiterplattenstreifens umfasst wenigstens ein elektrisches Kontaktpaar aufweisend zwei Kontaktierflächen ai und bi oder a'i und b'i, wobei die zwei Kontaktierflächen vorzugsweise entweder in einem ersten Bereich (oberen Bereich), der durch die in Längserstreckung ausgebildeten Mittenachse MA des flexiblen Leiterplattenstreifens 1 von einem zweiten Bereich (unteren Bereich) getrennt ist, oder in dem zweiten Bereich zusammen angeordnet sind.

Gemäß Fig. 1 sind die beiden Kontaktierflächen, z.B. ai und bi, eines elektrischen Kontaktpaares auf einer Achse parallel zu der in Längserstreckung ausgebildeten Mittenachse MA des flexiblen Leiterplattenstreifens angeordnet. Vorzugsweise kann die Anordnung der beiden Kontaktierflächen eines elektrischen Kontaktpaares 4 auch von einer solchen Achse abweichen.

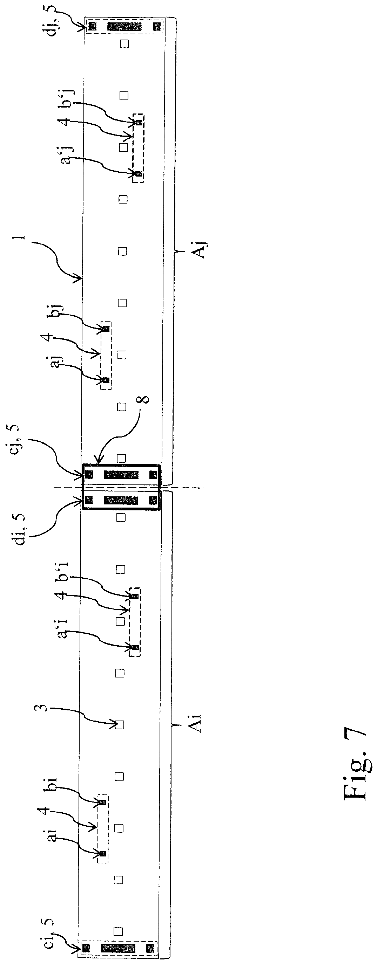

An den beiden Enden der Längsachse des Abschnitts Ai der flexiblen Leiterplattenstreifens 1 ist jeweils eine Verbindungsfläche 5 auf dem flexiblen Leiterplattenstreifen 1 angeordnet. Diese Verbindungsflächen 5 erlauben es mehrere einzelne voneinander getrennte Abschnitte Ai eines flexiblen Leiterplattenstreifens 1 wieder miteinander elektrisch zu verbinden. Dies wird noch näher bezüglich Figur 7 beschrieben.

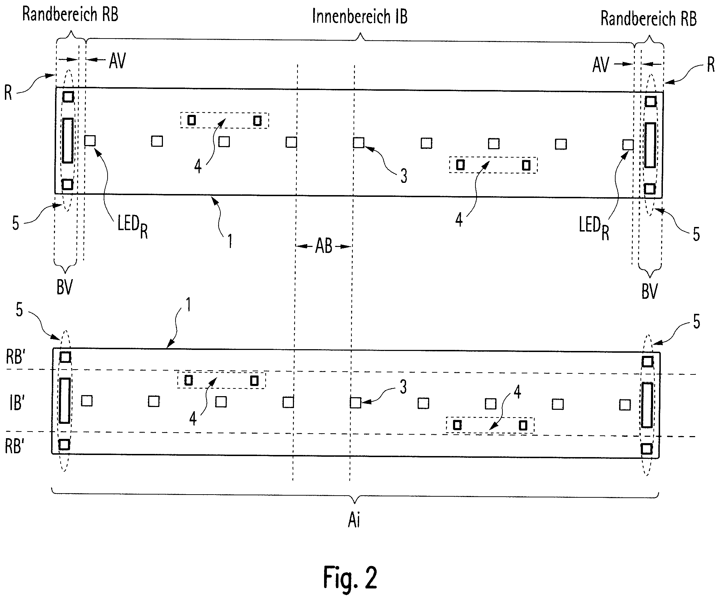

Figur 2 zeigt zwei schematische Draufsichten auf einen Abschnitt einer bevorzugten Ausführungsform eines erfindungsgemäßen flexiblen Leiterplattenstreifens, wobei sowohl die in Längserstreckung des flexiblen Leiterplattenstreifens ausgebildeten Randbereiche und Innenbereich (oben) wie auch die in Quererstreckung des flexiblen Leiterplattenstreifens ausgebildeten Randbereiche und Innenbereich (unten) gezeigt sind.

Die in Figur 2 gezeigte bevorzugte Ausführungsform eines erfindungsgemäßen flexiblen Leiterplattenstreifens entspricht der in Figur 1 gezeigten bevorzugten Ausführungsform eines erfindungsgemäßen flexiblen Leiterplattenstreifens.

In dem oberen Abschnitt Ai werden ein bezüglich der Längserstreckung des flexiblen Leiterplattenstreifens 1 ausgebildeter Innenbereich IB und die beiden Randbereiche RB, die an gegenüberliegenden Seiten an den Innenbereich IB angrenzen, gezeigt. Der Randbereich RB des Abschnitts Ai entspricht dem Bereich zwischen dem jeweiligen Rand R des Abschnitts Ai und der dem jeweiligen Rand R nächstgelegenen LED (LED_{R}). Somit weist der Randbereich RB vorzugsweise eine Länge von 50% des Abstands AB zwischen zwei benachbarten LEDs auf, damit eine äquidistante Verteilung bzw. Anordnung der LEDs in einer Reihe über den gesamten flexiblen Leiterplattenstreifen möglich ist. Mit anderen Worten sind die LEDs auf dem flexiblen Leiterplattenstreifen vorzugsweise in einer Reihe äquidistant angeordnet, d.h. der Abstand AB zwischen zwei benachbarten LEDs ist vorzugsweise auf dem flexiblen Leiterplattenstreifen für alle LEDs derselbe. Eine äquidistante Verteilung der LEDs ist vorteilhaft, da bei uneinheitlichen Abständen AB zwischen benachbarten LEDs periodische Helligkeitsschwankungen wahrgenommen werden können, welche das Erscheinungsbild einschränken.

Die LEDs 3 sowie die zwei elektrischen Kontaktpaare 4 aufweisend jeweils zwei Kontaktierflächen sind vorzugsweise in dem in Längserstreckung ausgebildeten Innenbereich IB auf dem flexiblen Leiterplattenstreifen 1 angeordnet. In jedem der zwei in Längserstreckung ausgebildeten Randbereiche RB ist vorzugsweise eine Verbindungsfläche 5 auf dem flexiblen Leiterplattenstreifen angeordnet, wobei die Verbindungsfläche 5 vorzugsweise jeweils in einem Bereich BV angeordnet ist, der ausgehend von dem jeweiligen Rand R des Abschnitts Ai 35% des Abstands AB zwischen zwei benachbarten LEDs nicht überschreitet. Mit anderen Worten ist zwischen einer in einem Randbereich RB angeordneten Verbindungsfläche 5 und der entsprechenden dem jeweiligen Rand R des Abschnitts Ai nächstgelegenen LED (LED_{R}) ein Abstand AV vorgesehen, der mindestens 15% des Abstands AB zwischen zwei benachbarten LEDs entspricht.

In dem unteren Abschnitt Ai werden ein bezüglich der Quererstreckung des flexiblen Leiterplattenstreifens 1 ausgebildeter Innenbereich IB' und die beiden Randbereiche RB', die an gegenüberliegenden Seiten an den Innenbereich IB' angrenzen, gezeigt. Der Innenbereich IB' ist durch die Breite der LEDs sowie durch die notwendige Kühlung der LEDs limitiert. Die minimale Breite des Innenbereichs ist vorzugsweise etwa 4 mm breit. Im Außenbereich bzw. den Randbereichen RB' sind vorzugsweise die Leiterbahnen zur Verteilung des Stromes auf der flexiblen Leiterplattenstreifen angeordnet. Vorzugsweise weisen die Randbereiche RB' jeweils eine Breite von zumindest 3 mm auf. In Summe ergibt sich vorzugsweise eine minimale Breite des flexiblen Leiterplattenstreifens, welche der Summe der Breiten der zwei Randbereiche RB' und des Innenbereichs IB' entspricht, von 10 mm. Vorzugsweise ist die Breite des flexiblen Leitertplattenstreifens zwischen 10 mm und 50 mm, besonders bevorzugt zwischen 10 mm und 24 mm, ganz besonders bevorzugt zwischen 16 und 24 mm, um eine ausreichende Kühlung und Stromverteilung zu gewährleisten.

Die LEDs 3 sowie die zwei elektrischen Kontaktpaare 4 aufweisend jeweils zwei Kontaktierflächen sind vorzugsweise in dem in Quererstreckung ausgebildeten Innenbereich IB' auf dem flexiblen Leiterplattenstreifen angeordnet.

In einem Abschnitt Ai des flexiblen Leiterplattenstreifens sind vorzugsweise die LEDs 3 und/oder das wenigstens eine elektrische Kontaktpaar 4 sowohl in dem bezüglich der Längserstreckung des Abschnitts Ai gebildeten Innenbereich IB wie auch in dem bezüglich der Quererstreckung des Abschnitts Ai gebildeten Innenbereich IB' auf dem flexiblen Leiterplattenstreifen 1 angeordnet.

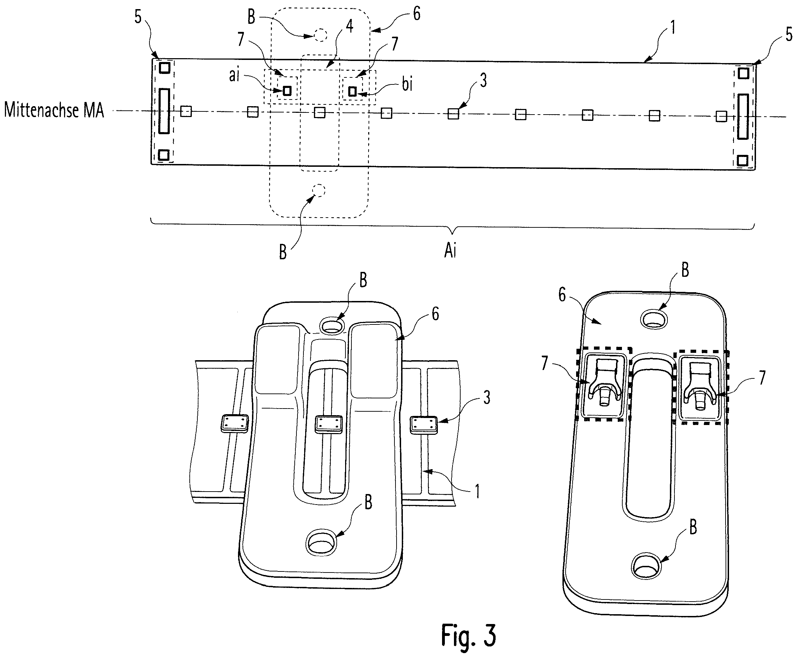

Figur 3 zeigt eine schematische Draufsicht auf einen Abschnitt einer bevorzugten Ausführungsform eines erfindungsgemäßen flexiblen Leiterplattenstreifens sowie schematische Draufsichten auf eine bevorzugte Ausführungsform einer erfindungsgemäßen Kontaktierbrücke zur elektrischen Kontaktierung des elektrischen Leiterplattenstreifens.

Die in Figur 2 gezeigte bevorzugte Ausführungsform eines erfindungsgemäßen flexiblen Leiterplattenstreifens entspricht im Wesentlichen der in den Figuren 1 und 2 gezeigten bevorzugten Ausführungsform eines erfindungsgemäßen flexiblen Leiterplattenstreifens. Im Gegensatz zu den in den Figuren 1 und 2 gezeigten Abschnitt Ai weist der in Figur 3 gezeigte Abschnitt Ai nur ein elektrisches Kontaktpaar 4 auf.

Im unteren Bereich der Figur 3 ist eine bevorzugte Ausführungsform der Kontaktierbrücke 6 zur elektrischen Kontaktierung der beiden Kontaktierflächen ai, bi eines elektrischen Kontaktpaares 4 eines Abschnitts Ai des flexiblen Leiterplattenstreifens 1 gezeigt. Die Kontaktierbrücke entspricht vorzugsweise einer Klemme bzw. einer Klammer, die in Quererstreckung des flexiblen Leiterplattenstreifens quer zu dem flexiblen Leiterplattenstreifen vorzugsweise auf dem flexiblen Leiterplattenstreifen angeordnet wird, sodass die zwei Kontaktiereinheiten 7 der Kontaktierbrücke 6 die beiden Kontaktierflächen ai und bi des elektrischen Kontaktpaares 4 elektrisch kontaktieren. Vorzugsweise wird die als Klammer bzw. Klemme ausgebildete Kontaktierbrücke 6 in Quererstreckung des flexiblen Leiterplattenstreifens 1 auf den flexiblen Leiterplattenstreifen 1 geschoben, um die beiden Kontaktierflächen ai und bi des elektrischen Kontaktpaares 4 durch die zwei Kontaktiereinheiten 7 der Kontaktierbrücke 6 elektrisch zu kontaktieren.

Vorzugsweise kann die Kontaktierbrücke 6 auch nur eine Kontaktiereinheit 7 zum elektrischen Kontaktieren einer der beiden Kontaktierflächen ai, bi eines elektrischen Kontaktpaares 4 aufweisen. In einem solchen Fall werden dann zwei, vorzugsweise als Klemmen bzw. Klammern ausgebildete, Kontaktierbrücken 6 zur elektrischen Kontaktierung eines elektrischen Kontaktpaares 4 aufweisend zwei Kontaktierflächen verwendet.

Wie in Figur 3 gezeigt, ist die als Klemme bzw. Klammer ausgebildete Kontaktierbrücke 6 derart auf dem flexiblen Leiterplattenstreifen 1 angeordnet, dass keine LEDs 3 durch die Kontaktierbrücke 6 abgeschirmt werden. Ferner weist die Kontaktierbrücke 6 vorzugsweise Durchgangsöffnungen bzw. Bohrungen B auf, durch die der Abschnitt Ai des flexiblen Leiterplattenstreifens zusammen mit der Kontaktierbrücke 6 auf einem Träger montiert werden kann.

Folglich dient die Kontaktierbrücke 6 nicht nur zur elektrischen Kontaktierung des elektrischen Kontaktpaares 4, sondern vorzugsweise auch zur Befestigung des Abschnitts Ai des flexiblen Leiterplattenstreifens 1 auf einem Träger. Zum Beispiel können Befestigungselemente, wie z.B. Schrauben, durch die Durchgangsöffnungen bzw. Bohrungen B geführt werden, um den flexiblen Leiterplattenstreifen 1 zusammen mit der Kontaktierbrücke 6 auf eine Träger derart zu montieren, dass der flexible Leiterplattenstreifen 1 zwischen dem Träger und der Kontaktierbrücke angeordnet ist.

Vorzugsweise entsprechen die Kontaktiereinheiten 7 der Kontaktierbrücke 6 elektrischen Federkontakten.

Vorzugsweise werden die Kontaktierbrücken 6 zur elektrischen Kontaktierung der Abschnitte Ai des flexiblen Leiterplattenstreifens 1 durch einen Fertigungsroboter automatisch angeordnet.

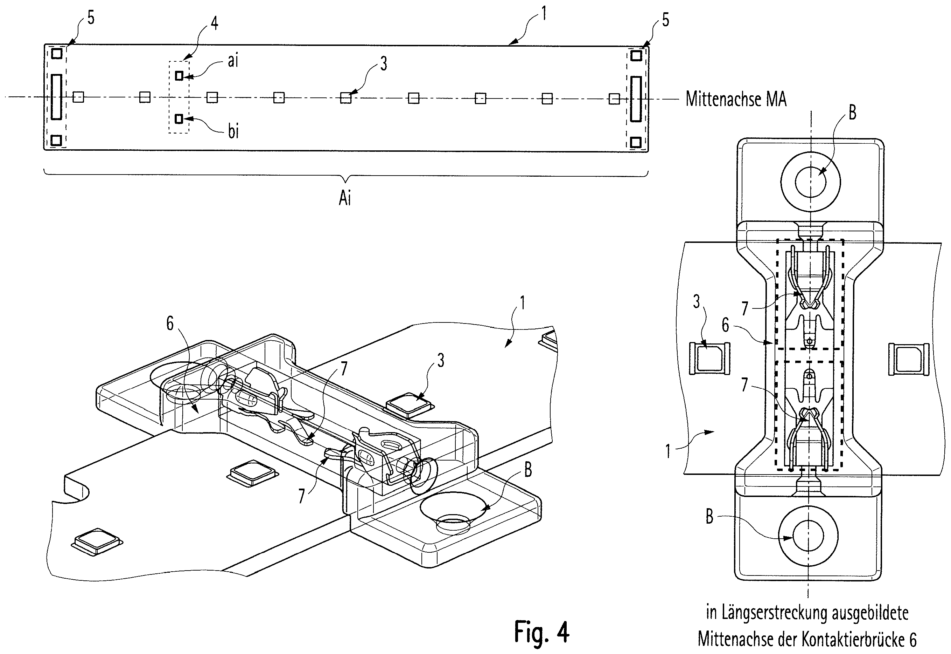

Figur 4 zeigt eine schematische Draufsicht auf einen Abschnitt einer bevorzugten Ausführungsform eines erfindungsgemäßen flexiblen Leiterplattenstreifens sowie schematische Draufsichten auf eine weitere bevorzugte Ausführungsform einer erfindungsgemäßen Kontaktierbrücke zur elektrischen Kontaktierung des elektrischen Leiterplattenstreifens.

Die in Figur 4 gezeigte bevorzugte Ausführungsform eines erfindungsgemäßen flexiblen Leiterplattenstreifens entspricht im Wesentlichen der in Figur 3 gezeigten bevorzugten Ausführungsform eines erfindungsgemäßen flexiblen Leiterplattenstreifens.

Im Gegensatz zu der Figur 3 sind in dem Abschnitt Ai des flexiblen Leiterplattenstreifens 1 gemäß der Figur 4 die zwei Kontaktierflächen ai und bi des elektrischen Kontaktpaares 4 bezüglich der in Längserstreckung ausgebildeten Mittenachse MA des Abschnitts Ai des flexiblen Leiterplattenstreifens 1 auf gegenüberliegenden Seiten angeordnet. Die Kontaktierfläche ai ist bezüglich der in Längserstreckung ausgebildeten Mittenachse MA in einem oberen Bereich (ersten Bereich) angeordnet, der an einen bezüglich der in Längserstreckung ausgebildeten Mittenachse MA unteren Bereich (zweiten Bereich) angrenzt. Die Kontaktierfläche bi ist gegenüberliegend zu der Kontaktierfläche ai in dem unteren Bereich (zweiten Bereich) angeordnet.

Die Kontaktierbrücke 6 gemäß Figur 4 weist nun zwei Kontaktiereinheiten 7 auf, die in Längserstreckung der Kontaktierbrücke 6 auf gegenüberliegenden Seiten in der Kontaktierbrücke 6 angeordnet sind. D.h. bezüglich der in Quererstreckung ausgebildeten Mittenachse der Kontaktierbrücke 6 sind die zwei Kontaktiereinheiten 7 in der Kontaktierbrücke 6 gegenüberliegend angeordnet.

Die Kontaktierbrücke 6 gemäß der Figur 4 wird in Quererstreckung des flexiblen Leiterplattenstreifens 1 quer zu dem flexiblen Leiterplattenstreifen 1 und vorzugsweise auf dem flexiblen Leiterplattenstreifen 1 angeordnet, sodass die Kontaktiereinheiten 7 der Kontaktierbrücke 6 die beiden Kontaktierflächen ai und bi des elektrischen Kontaktpaares 4, die bezüglich der in Längserstreckung ausgebildeten Mittenachse des Abschnitts Ai gegenüberliegend angeordnet sind, elektrisch kontaktieren.

Vorzugsweise ist die Kontaktierbrücke 6 derart auf dem Abschnitt Ai des flexiblen Leiterplattenstreifens 1 zur elektrischen Kontaktierung des elektrischen Kontaktpaares 4 des Abschnitts Ai angeordnet, dass keine LEDs 3 des Abschnitts Ai durch die Kontaktierbrücke 6 abgeschirmt werden.

Vorzugsweise dient die Kontaktierbrücke 6 gemäß der Figur 4, genau wie die Kontaktierbrücke 6 gemäß der Figur 3, nicht nur einer elektrischen Kontaktierung des elektrischen Kontaktpaares 4, sondern auch einer Befestigung des Abschnitts Ai des flexiblen Leiterplattenstreifens 1 zusammen mit der Kontaktierbrücke 6 auf einem Träger. Hierfür weist die Kontaktierbrücke vorzugsweise Durchgangsöffnungen bzw. Bohrungen B auf, sodass die Kontaktierbrücke 6 zur elektrischen Kontaktierung des elektrischen Kontaktpaares 4 des Abschnitts Ai und zur Befestigung des Abschnitts Ai auf einen Träger an den Träger durch ein Befestigungsmittel, wie z.B. Schrauben, befestigt bzw. montiert werden kann.

Die Kontaktiereinheiten 7 der Kontaktierbrücke 6 sind vorzugsweise elektrische Federkontakte.

Vorzugsweise werden die Kontaktierbrücken 6 zur elektrischen Kontaktierung der Abschnitte Ai des flexiblen Leiterplattenstreifens 1 durch einen Fertigungsroboter automatisch angeordnet.

Figur 5 zeigt eine schematische Draufsicht auf eine bevorzugte Ausführungsform eines erfindungsgemäßen flexiblen Leiterplattenstreifens (linke Seite der Figur 5) sowie einen schematischen Schaltplan einer bevorzugte Ausführungsform einer elektrischen Verschaltung der LEDs auf dem flexiblen Leiterplattenstreifen (rechte Seite der Figur 5).

Die in Figur 5 gezeigte bevorzugte Ausführungsform eines erfindungsgemäßen flexiblen Leiterplattenstreifens entspricht der in Figur 1 gezeigten bevorzugten Ausführungsform eines erfindungsgemäßen flexiblen Leiterplattenstreifens.

Wie in Figur 5 gezeigt, sind die LEDs 3 eines Abschnitts A1, A2 und A3 vorzugsweise seriell miteinander elektrisch verbunden. Die Serienschaltung aus LEDs 3 des Abschnitts A1 kann vorzugsweise über das Kontaktpaar 4 aufweisend die Kontaktierflächen a1 und b1 betrieben werden. Mit anderen Worten können die LEDs 3 des Abschnitts A1 dadurch betrieben werden, dass die Kontaktierflächen a1 und b1 elektrisch kontaktiert werden, vorzugsweise mit einem Konverter zum Betreiben von LEDs 3 elektrisch verbunden werden, und über die beiden Kontaktierflächen a1 und b1 eine zum Betreiben der LEDs 3 entsprechende Spannung zugeführt wird. Mit anderen Worten kann über die Kontaktierflächen a1 und b1 eine Spannung an die Serienschaltung aus LEDs 3 des Abschnitts A1 angelegt werden, um die LEDs 3 zum Leuchten bzw. zur Lichtemission zu bringen. Über die Kontaktierflächen a1' und b1' kann vorzugsweise nur einem Teil der seriell elektrisch verbundenen LEDs 3 des Abschnitts A1 eine Spannung zugeführt werden. Das Vorstehende bezüglich der elektrischen Verschaltung der LEDs 3 des Abschnitts A1 ist auch für die anderen Abschnitte, z.B. A2 und A3, des flexiblen Leiterplattenstreifens 1 zutreffend.

Vorzugsweise ist jedem Abschnitt des flexiblen Leiterplattenstreifens 1 die Anzahl an LEDs 3 in einer Serienschaltung auf eine vorbestimmte Anzahl begrenzt. Diese vorbestimmte Anzahl an LEDs ist derart, dass die aufgrund der Anzahl an LEDs resultierende kombinierte Durchflussspannung einer SELV-Spannung entspricht. Aufgrund der Gefahr einer ungleichmäßigen Stromaufteilung sind vorzugsweise zumindest 6 LEDs in Serie geschaltet, wobei vorzugsweise maximal 18 LEDs, besonders vorzugsweise maximal 16 LEDs in Serie geschaltet werden. Die Spannung am Ausgang des Konverters, der die LEDs eines Abschnitts elektrisch versorgt, darf vorzugsweise 60 V nicht übersteigen.

Figur 6 zeigt eine schematische Draufsicht auf einen Abschnitt einer weiteren bevorzugte Ausführungsform eines erfindungsgemäßen flexiblen Leiterplattenstreifens (linke Seite der Figur 6) sowie einen schematischen Schaltplan einer bevorzugte Ausführungsform einer elektrischen Verschaltung der LEDs in dem Abschnitt auf dem flexiblen Leiterplattenstreifen (rechte Seite der Figur 6).

In Figur 6 ist der Fall gezeigt, bei dem ein Abschnitt Ai eines flexiblen Leiterplattenstreifens 1 derart viele LEDs aufweist, dass eine serielle elektrische Verschaltung aller LEDs eines Abschnitts Ai eine kombinierte Durchflussspannung verursacht die größer als eine SELV-Spannung ist.

Folglich werden die LEDs 3 in dem Abschnitt Ai in Unterabschnitte UA1, UA2 und UA3 aufgeteilt, wobei die LEDs 3 in jedem Unterabschnitt seriell elektrisch verbunden sind und die Unterabschnitte UA1, UA2 und UA3 an Serienschaltungen von LEDs 3 zueinander parallel verschaltet werden.

Dies ist auf der rechten Seite der Figur 6 gezeigt, in der die in Serie geschalteten LEDs 3 des Unterabschnitts UA1 parallel mit den in Serie geschalteten LEDs 3 des Unterabschnitts UA2 und den in Serie geschalteten LEDs 3 des Unterabschnitts UA3 elektrisch verbunden sind.

Die Anzahl an parallel verschalteten bzw. elektrisch verbundenen Unterabschnitten UA1, UA2 und UA3 in jedem Abschnitt Ai des flexiblen Leiterplattenstreifens 1 ist durch den Strom zum Betreiben der Abschnitte Ai bestimmt. Vorzugsweise ist in jedem Abschnitt Ai die Anzahl an Unterabschnitten UA1, UA2 und UA3 auf eine vorbestimmte Anzahl an Unterabschnitten begrenzt bzw. limitiert, wobei diese vorbestimmte Anzahl an Unterabschnitten derart ist, dass der zum Betreiben der vorbestimmten Anzahl an Unterabschnitten benötigte Strom kleiner als ein vorbestimmter Strom ist. Dieser vorbestimmte Strom beträgt vorzugsweise zwischen 14 mA und 500 mA, besonders vorzugsweise zwischen 60 mA und 180 mA. Mit einem solchen Strombereich kann eine breite Palette an Lichtströmen realisiert werden, z.B. kann bei 60 mA ein Lichtstrom von etwa 2500 lm/m und bei 180 mA ein Lichtstrom von etwa 7000 lm/m erreicht werden.

Figur 7 zeigt eine schematische Draufsicht auf zwei Abschnitte einer bevorzugte Ausführungsform eines erfindungsgemäßen flexiblen Leiterplattenstreifens, die durch eine Kontaktierungsleiterplatte miteinander elektrisch verbunden sind.

Die in Figur 7 gezeigte bevorzugte Ausführungsform eines erfindungsgemäßen flexiblen Leiterplattenstreifens entspricht der in Figur 1 gezeigten bevorzugten Ausführungsform eines erfindungsgemäßen flexiblen Leiterplattenstreifens.

Vorzugsweise kann ein separater Abschnitt Ai des flexiblen Leiterplattenstreifens 1 mit einem anderen separaten Abschnitt Aj des flexiblen Leiterplattenstreifens 1 durch eine Kontaktierungsleiterplatte 8 elektrisch verbunden werden. Hierfür wird die Kontaktierungsleiterplatte 8 sowohl mit einer Verbindungsfläche 5 des einen Abschnitts Ai wie auch mit einer Verbindungsfläche 5 des anderen Abschnitts Aj elektrisch verbunden.

Vorzugsweise sind auf dem flexiblen Leiterplattenstreifen 1 die Abschnitte Ai elektrisch verbunden. Für den Fall, dass die einzelnen Abschnitte Ai des flexiblen Leiterplattenstreifens 1 voneinander getrennt werden, können einzelne separate Abschnitte durch die Kontaktierungsleiterplatte 8 wieder miteinander elektrischen verbunden werden. Folglich können durch mehrere Kontaktierungsleiterplatten 8 separate Abschnitte Ai derart miteinander verschaltet bzw. elektrisch verbunden werden, dass aus den separaten Abschnitten Ai wieder ein flexibler Leiterplattenstreifen 1 gebildet wird.

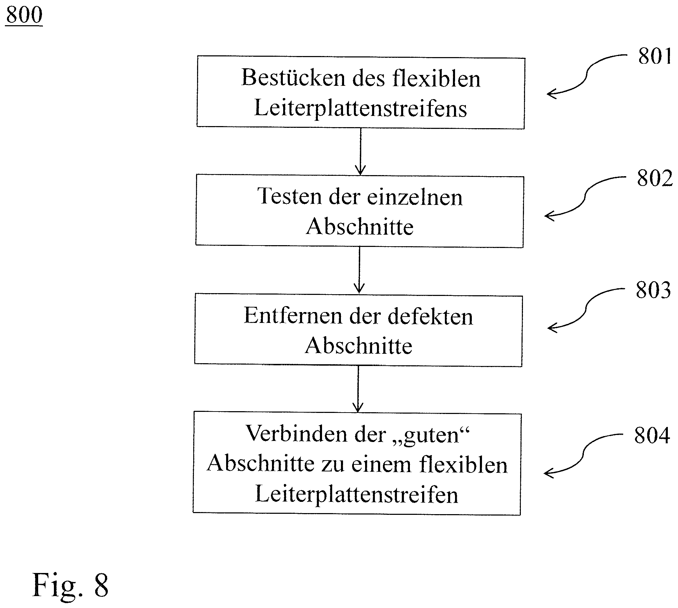

Figur 8 zeigt eine bevorzugte Ausführungsform eines erfindungsgemäßen Verfahrens zur Herstellung eines erfindungsgemäßen flexiblen Leiterplattenstreifens ohne defekte Abschnitte.

Gemäß dem Verfahrensschritt 801 wird der flexible Leiterplattenstreifen 1 automatisch durch einen Bestückungsroboter mit LEDs 3 bestückt, welche gemäß den vorstehenden Ausführungen durch den flexiblen Leiterplattenstreifen 1 elektrisch verbunden werden. D.h. der flexible Leiterplattenstreifen weist eine erfindungsgemäße vorstehend beschriebene elektrische Verschaltung für die auf dem flexiblen Leiterplattenstreifen 1 in einer Reihe anzuordnenden LEDs 3 auf. Hierbei sind die auf dem flexiblen Leiterplattenstreifen 1 angeordneten LEDs 3 derart elektrisch verschaltet, dass der flexible Leiterplattenstreifen derart in gleiche Abschnitte Ai aufgeteilt ist, dass jeder Abschnitt Ai bzw. die LEDs 3 jedes Abschnitts Ai separat elektrisch kontaktierbar sind und somit separat betreibbar sind. Mit anderen Worten, wenn ein Abschnitt Ai aus dem flexiblen Leiterplattenstreifen 1 entfernt bzw. ausgeschnitten wird, dann kann dieser Abschnitt Ai bzw. die LEDs 3 dieses Abschnitts immer noch elektrisch betrieben werden.

Auf den Verfahrensschritt 801 folgt der Verfahrensschritt 802, in dem die einzelnen Abschnitte Ai bzw. die LEDs jedes Abschnitts Ai des flexiblen Leiterplattenstreifens 1 auf ihre Funktionsfähigkeit getestet werden.

Auf den Verfahrensschritt 802 folgt der Verfahrensschritt 803, in dem die defekten Abschnitte, d.h. die nicht funktionsfähigen Abschnitte, aus dem flexiblen Leiterplattenstreifen entfernt bzw. herausgeschnitten werden.

In dem Verfahrensschritt 804, der auf den Verfahrensschritt 803 folgt, werden dann die übrig gebliebenen "guten" Abschnitte Ai, d.h. die funktionsfähigen Abschnitte Ai, durch Kontaktierungsleiterplatten 8 miteinander elektrisch verbunden, um einen flexiblen Leiterplattenstreifen 1 zu erzeugen, der nur funktionsfähige Abschnitte Ai umfasst.

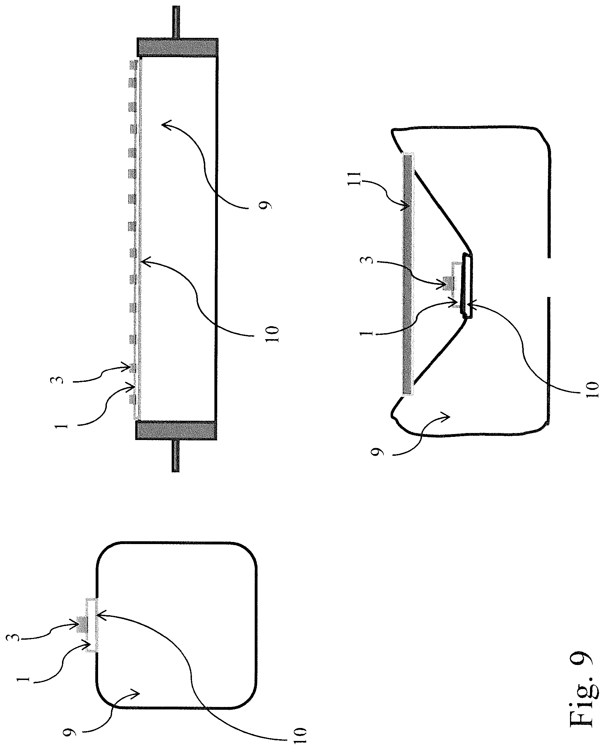

Figur 9 zeigt eine schematische Seitenansicht auf eine bevorzugte Ausführungsform einer erfindungsgemäßen Leuchte aufweisend den erfindungsgemäßen flexiblen Leiterplattenstreifen.

Wie in Figur 9 gezeigt, kann der flexible Leiterplattenstreifen 1 in einer Leuchte 9, vorzugsweise einem Leuchtstoffröhrengehäuse, montiert bzw. befestigt werden. Hierfür kann die flexible Leiterplattenstreifen auf die gewünschte Länge zugeschnitten werden. D.h. wenigstens ein Abschnitt Ai des flexiblen Leiterplattenstreifens 1 wird vorzugsweise in der Leuchte 9 montiert.

Vorzugsweise wird der flexible Leiterplattenstreifen 1 auf eine Trägerplatte 10 der Leuchte 9 montiert bzw. befestigt. Diese Trägerplatte 10 ist vorzugsweise aus Metall, wie z.B. Aluminium, und dient als Kühlkörper zum Kühlen der LEDs 3 auf dem flexiblen Leiterplattenstreifen 1.

In der Leuchte 9 ist der flexible Leiterplattenstreifen durch wenigstens eine Kontaktierbrücke 6 für eine elektrische Energieversorgung der auf dem flexiblen Leiterplattenstreifen angeordneten LEDs 3 elektrisch kontaktiert (in Figur 9 nicht gezeigt). Hierbei kann die wenigstens eine Kontaktierbrücke 6 zusätzlich zur Befestigung des flexiblen Leiterplattenstreifens 1 auf der Trägerplatte 10 verwendet werden.

Der flexible Leiterplattenstreifen 1 ist vorzugsweise durch eine Klebeverbindung auf der Trägerplatte 10 befestigt bzw. montiert. Hierfür ist auf der Rückseite des flexiblen Leiterplattenstreifens 1 ein Klebestreifen angebracht oder es wird die Rückseite des flexiblen Leiterplattenstreifens mit einem Flüssigkleber bestrichen. Unter der *"Rückseite des flexiblen Leiterplattenstreifens"* wird die Seite des flexiblen Leiterplattenstreifens 1 verstanden, die der Seite des flexiblen Leiterplattenstreifens 1, auf der die LEDs angeordnet werden, gegenüberliegend ist.

Im unteren Bereich der Figur 9 ist ein Profil der Leuchte 9 gezeigt, bei dem die Trägerplatte 10 zurückgesetzt ist im Vergleich zu dem im oberen Bereich der Figur 9 gezeigten Profil der Leuchte 9. Vorzugsweise kann dann die Leuchte eine Diffusorscheibe 11 aufweisen.

Die Trägerplatte 10, der erfindungsgemäße flexible Leiterplattenstreifen 1 bzw. wenigstens ein Abschnitt des erfindungsgemäßen flexiblen Leiterplattenstreifens 1 und wenigstens eine erfindungsgemäße Kontaktierbrücke stellen vorzugsweise einen Einsatz für eine Leuchte dar. Dieser Einsatz kann dann in einer Leuchte eingesetzt bzw. angeordnet werden, um die Leuchte mit einer Lichtquelle in Form von LEDs zu versehen.

## Patentansprüche

1. Flexibler Leiterplattenstreifen (1) mit
- einer LED-Strecke (2) aufweisend elektrisch seriell verbundene LEDs (3);
- wobei die LED-Strecke (2) mehrere LEDs (3) aufweist, die in einer Reihe in Längserstreckung des flexiblen Leiterplattenstreifens (1) auf dem flexiblen Leiterplattenstreifen (1) angeordnet sind;
- wobei der flexible Leiterplattenstreifen (1) in eine Vielzahl von Abschnitten (A1, A2, A3, Ai, Aj) aufgeteilt ist und jeder Abschnitt (A1, A2, A3, Ai, Aj) eine vorbestimmten Anzahl an LEDs (3) umfasst,
- wobei jeder Abschnitt (A1, A2, A3, Ai, Aj) wenigstens ein elektrisches Kontaktpaar (4) aufweisend zwei Kontaktierflächen (a1, b1, a2, b2, a3, b3, ai, bi, aj, bj) zur elektrischen Kontaktierung der in dem jeweiligen Abschnitt (A1, A2, A3, Ai, Aj) vorhandenen LEDs (3) umfasst;
- wobei die zwei Kontaktierflächen (a1, b1, a2, b2, a3, b3, ai, bi, aj, bj) des wenigstens einen Kontaktpaares (4) in dem jeweiligen Abschnitt (A1, A2, A3, Ai, Aj) auf dem flexiblen Leiterplattenstreifen (1) derart angeordnet sind, dass die zwei Kontaktierflächen(a1, b1, a2, b2, a3, b3, ai, bi, aj, bj) durch wenigstens eine in Quererstreckung des flexiblen Leiterplattenstreifens (1) quer zu und vorzugsweise über dem flexiblen Leiterplattenstreifen (1) angeordnete Kontaktierbrücke (6) elektrisch kontaktierbar sind, wobei der flexible Leiterplattenstreifen **dadurch gekennzeichnet ist, dass** jeder Abschnitt (A1, A2, A3, Ai, Aj) in Längserstreckung des flexiblen Leiterplattenstreifens (1) zwei Randbereiche (RB) aufweist, die in Längserstreckung des flexiblen Leiterplattenstreifens (1) auf gegenüberliegenden Seiten des in Längserstreckung des flexiblen Leiterplattenstreifens (1) ausgebildeten Innenbereichs (IB) des jeweiligen Abschnitts (A1, A2, A3, Ai, Aj) liegen, und dass jeder Randbereich (RB) wenigstens eine Verbindungsfläche (5) aufweist, die derart in dem jeweiligen Randbereich (RB) auf dem flexiblen Leiterplattenstreifen (1) angeordnet ist, dass die Verbindungsfläche (5) eines Randbereichs (RB) eines Abschnitts (A1, A2, A3, Ai, Aj) des flexiblen Leiterplattenstreifens (1) mit der Verbindungsfläche (5) eines Randbereichs (RB) eines anderen Abschnitts (A1, A2, A3, Ai, Aj) des flexiblen Leiterplattenstreifens (1) durch eine Kontaktierungsleiterplatte (8) elektrisch verbindbar ist.

2. Flexibler Leiterplattenstreifen (1) gemäß Anspruch 1,
- wobei der flexible Leiterplattenstreifen (1) durch eine in Längserstreckung gebildete Mittenachse (MA) in einen ersten und zweiten Bereich aufgeteilt ist, und
- in jedem Abschnitt (A1, A2, A3, Ai, Aj) das wenigsten eine elektrische Kontaktpaar (4) in dem ersten oder zweiten Bereich angeordnet ist.

3. Flexibler Leiterplattenstreifen (1) gemäß Anspruch 1,
- wobei der flexible Leiterplattenstreifen (1) durch eine in Längserstreckung gebildete Mittenachse (MA) in einen ersten und zweiten Bereich aufgeteilt ist, und
- wobei in jedem Abschnitt (A1, A2, A3, Ai, Aj) eine erste Kontaktierfläche (a1, a2, a3, ai, aj) der zwei Kontaktierflächen (a1, b1, a2, b2, a3, b3, ai, bi, aj, bj) des wenigstens einen elektrischen Kontaktpaares (4) in dem ersten Bereich und eine zweite Kontaktierfläche (b1, b2, b3, bi, bj) der zwei Kontaktierflächen (a1, b1, a2, b2, a3, b3, ai, bi, aj, bj) des wenigstens einen elektrischen Kontaktpaares (4) in dem zweiten Bereich derart angeordnet sind, dass die erste Kontaktierfläche (a1, a2, a3, ai, aj) und die zweite Kontaktierfläche (b1, b2, b3, bi, bj)des wenigstens einen elektrischen Kontaktpaares (4) gegenüberliegend auf dem flexiblen Leiterplattenstreifen (1) angeordnet sind.

4. Flexibler Leiterplattenstreifen (1) gemäß einem der vorhergehenden Ansprüche, wobei in jedem Abschnitt (A1, A2, A3, Ai, Aj) die zwei Kontaktierflächen (a1, b1, a2, b2, a3, b3, ai, bi, aj, bj) des wenigstens einen elektrischen Kontaktpaares (4) in einem Innenbereich (IB, IB') des jeweiligen Abschnitts bezüglich der Längserstreckung und/oder Quererstreckung des flexiblen Leiterplattenstreifens (1) angeordnet sind.

5. Flexibler Leiterplattenstreifen (1) gemäß einem der vorhergehenden Ansprüche,
- wobei jeder Abschnitt (A1, A2, A3, Ai, Aj) dazu eingerichtet ist, derart aus dem flexiblen Leiterplattenstreifen (1) entfernbar zu sein, dass die LEDs (3) des jeweiligen Abschnitts (A1, A2, A3, Ai, Aj) elektrisch betreibbar sind.

6. Flexibler Leiterplattenstreifen (1) gemäß einem der vorhergehenden Ansprüche,
- wobei jeder Abschnitt (A1, A2, A3, Ai, Aj) wenigstens zwei Unterabschnitte (UA1, UA2, UA3) aufweist, die parallel miteinander elektrisch verbunden sind; und
- jeder Unterabschnitt (UA1, UA2, UA3) eine vorbestimmte Anzahl an LEDs (3), vorzugsweise elf LEDs, aufweist, die miteinander seriell elektrisch verbunden sind.

7. Flexibler Leiterplattenstreifen (1) gemäß Anspruch 6,
wobei die vorbestimmte Anzahl an LEDs (3) eines jeweiligen Unterabschnitts (UA1, UA2, UA3) derart ist, dass die durch die Anzahl an LEDs (3) verursachte Durchflussspannung einer SELV-Spannung entspricht.

8. Flexibler Leiterplattenstreifen (1) gemäß Anspruch 6 oder 7,
- wobei jeder Abschnitt (A1, A2, A3, Ai, Aj) eine vorbestimmte Anzahl an Unterabschnitten (UA1, UA2, UA3) aufweist; und
- wobei die vorbestimmte Anzahl an Unterabschnitten (UA1, UA2, UA3) derart ist, dass der zum Betreiben der vorbestimmten Anzahl an Unterabschnitten (UA1, UA2, UA3) benötigte Strom kleiner als ein vorbestimmter Strom, wobei der vorbestimmte Strom vorzugsweise zwischen 14 mA und 500 mA, besonders vorzugsweise zwischen 60 mA und 180 mA ist.

9. System mit
- einem flexiblen Leiterplattenstreifen (1) gemäß einem der vorhergehenden Ansprüche; und
- wenigstens einer Kontaktierbrücke (6), die wenigstens eine Kontaktiereinheit (7) aufweist und dazu eingerichtet ist, durch Anordnung in Quererstreckung des flexiblen Leiterplattenstreifens (1) quer zu und vorzugsweise über dem flexiblen Leiterplattenstreifen (1) wenigstens eine Kontaktierfläche (a1, b1, a2, b2, a3, b3, ai, bi, aj, bj) eines Abschnitts (A1, A2, A3, Ai, Aj) des flexiblen Leiterplattenstreifens (1) durch die wenigstens eine Kontaktiereinheit (7) elektrisch zu kontaktieren.
wobei vorzugsweise die wenigstens eine Kontaktiereinheit (7) einem elektrischen Federkontakt entspricht.

10. System gemäß Anspruch 9, wobei die Kontaktierbrücke (6) zwei Kontaktiereinheiten (7) aufweist und dazu eingerichtet ist durch die zwei Kontaktiereinheiten (7) zwei Kontaktierflächen ((a1, b1, a2, b2, a3, b3, ai, bi, aj, bj) eines elektrischen Kontaktpaares (4) eines Abschnitts (A1, A2, A3, Ai, Aj) des flexiblen Leiterplattenstreifens (1) elektrisch zu kontaktieren.

11. System gemäß Anspruch 10,
- wobei der flexible Leiterplattenstreifen (1) durch eine in Längserstreckung gebildete Mittenachse (MA) in einen ersten und zweiten Bereich aufgeteilt ist, und
- die zwei Kontaktiereinheiten (7) der Kontaktierbrücke (6) in Längserstreckung der Kontaktierbrücke (6) auf der Kontaktierbrücke (6) derart gegenüberliegend angeordnet sind, dass die Kontaktierbrücke (6) dazu eingerichtet ist, zwei Kontaktierflächen (a1, b1, a2, b2, a3, b3, ai, bi, aj, bj) eines elektrischen Kontaktpaares (4) eines Abschnitts (A1, A2, A3, Ai, Aj) des flexiblen Leiterplattenstreifens (1) durch die zwei Kontaktiereinheiten (7) elektrisch zu kontaktieren, wobei eine erste Kontaktierfläche (a1, a2, a3, ai, aj) der wenigsten zwei Kontaktierflächen (a1, b1, a2, b2, a3, b3, ai, bi, aj, bj) des elektrischen Kontaktpaares (4) in dem ersten Bereich und eine zweite Kontaktierfläche (a1, a2, a3, ai, aj) der wenigsten zwei Kontaktierflächen (a1, b1, a2, b2, a3, b3, ai, bi, aj, bj) des elektrischen Kontaktpaares (4) in dem zweiten Bereich des flexiblen Leiterplattenstreifens (1) gegenüberliegend angeordnet sind.

12. Einsatz für eine Leuchte (9), wobei der Einsatz
- wenigstens einen Abschnitt (A1, A2, A3, Ai, Aj) des flexiblen Leiterplattenstreifens (1) gemäß den Ansprüchen 1 bis 8,
- wenigstens eine Kontaktierbrücke (6) wie in den Ansprüchen 9 bis 11 definiert, und
- eine Trägerplatte (10) aufweist; wobei
- der wenigstens eine Abschnitt (A1, A2, A3, Ai, Aj) auf der Trägerplatte (10) montiert ist; und
- die zwei Kontaktierflächen (a1, b1, a2, b2, a3, b3, ai, bi, aj, bj) des wenigstens einen elektrischen Kontaktpaares (4) des wenigstens einen Abschnitts (A1, A2, A3, Ai, Aj) durch die wenigstens eine Kontaktierbrücke (6) elektrisch kontaktiert sind.

13. Einsatz für eine Leuchte (9) gemäß Anspruch 12, wobei die Trägerplatte (10) aus Metall, vorzugsweise Aluminium ist, und einen Kühlkörper darstellt.

14. Einsatz für eine Leuchte (9) gemäß Anspruch 12 oder 13, wobei der wenigstens eine Abschnitt (A1, A2, A3, Ai, Aj) des flexiblen Leiterplattenstreifens (1) durch eine Klebverbindung, vorzugsweise Klebeband oder Flüssigkleber, auf der Trägerplatte (10) montiert ist.

## Claims

1. Flexible circuit board strip (1) having
- an LED section (2) comprising electrically serially connected LEDs (3);
- wherein the LED section (2) comprises a plurality of LEDs (3) which are disposed on the flexible circuit board strip (1) in a row along the longitudinal extension of the flexible circuit board strip (1);
- wherein the flexible circuit board strip (1) is divided into a plurality of sections (A1, A2, A3, Ai, Aj) and each section (A1, A2, A3, Ai, Aj) comprises a predetermined number of LEDs (3) ,
- wherein each section (A1, A2, A3, Ai, Aj) comprises at least one electrical pair of contacts (4) having two contacting surfaces (a1, b1, a2, b2, a3, b3, ai, bi, aj, bj) for electrically contacting the LEDs (3) present in the respective section (A1, A2, A3, Ai, Aj);
- wherein the two contacting surfaces (a1, b1, a2, b2, a3, b3, ai, bi, aj, bj) of the at least one pair of contacts (4) in the respective section (A1, A2, A3, Ai, Aj) are disposed on the flexible circuit board strip (1) such that the two contacting surfaces (a1, b1, a2, b2, a3, b3, ai, bi, aj, bj) are electrically contactable by at least one contacting bridge (6) which is disposed along the transverse extension of the flexible circuit board strip (1) perpendicular to and preferably above the flexible circuit board strip (1), wherein the flexible circuit board strip is **characterized in that** each section (A1, A2, A3, Ai, Aj) along the longitudinal extension of the flexible circuit board strip (1) comprises two edge regions (RB) which are located along the longitudinal extension of the flexible circuit board strip (1) on opposite sides of the inner region (IB) of the respective section (A1, A2, A3, Ai, Aj) configured along the longitudinal extension of the flexible circuit board strip (1), and
that each edge region (RB) comprises at least one connecting surface (5), which is disposed in the respective edge region (RB) on the flexible circuit board strip (1) such that the connecting surface (5) of an edge region (RB) of a section (A1, A2, A3, Ai, Aj) of the flexible circuit board strip (1) can be electrically connected to the connecting surface (5) of an edge region (RB) of another section (A1, A2, A3, Ai, Aj) of the flexible circuit board strip (1) by means of a contacting circuit board (8).

2. Flexible circuit board strip (1) according to Claim 1,
- wherein the flexible circuit board strip (1) is divided into a first and second region by a center axis (MA) formed in longitudinal extension, and,
- in each section (A1, A2, A3, Ai, Aj), the at least one electrical pair of contacts (4) is disposed in the first or second region.

3. Flexible circuit board strip (1) according to Claim 1,
- wherein the flexible circuit board strip (1) is divided into a first and second region by a center axis (MA) formed in longitudinal extension, and
- wherein, in each section (A1, A2, A3, Ai, Aj), a first contacting surface (a1, a2, a3, ai, aj) of the two contacting surfaces (a1, b1, a2, b2, a3, b3, ai, bi, aj, bj) of the at least one electrical pair of contacts (4) in the first region and a second contacting surface (b1, b2, b3, bi, bj) of the two contacting surfaces (a1, b1, a2, b2, a3, b3, ai, bi, aj, bj) of the at least one electrical pair of contacts (4) in the second region are disposed such that the first contacting surface (a1, a2, a3, ai, aj) and the second contacting surface (b1, b2, b3, bi, bj) of the at least one electrical pair of contacts (4) are disposed opposite one another on the flexible circuit board strip (1).

4. Flexible circuit board strip (1) according to any one of the preceding claims, wherein, in each section (A1, A2, A3, Ai, Aj), the two contacting surfaces (a1, b1, a2, b2, a3, b3, ai, bi, aj, bj) of the at least one electrical pair of contacts (4) are disposed in an inner region (IB, IB') of the respective section with respect to the longitudinal extension and/or the transverse extension of the flexible circuit board strip (1).

5. Flexible circuit board strip (1) according to any one of the preceding claims,
- wherein each section (A1, A2, A3, Ai, Aj) is configured to be removable from the flexible circuit board strip (1) such that the LEDs (3) of the respective section (A1, A2, A3, Ai, Aj) are electrically operable.

6. Flexible circuit board strip (1) according to any one of the preceding claims,
- wherein each section (A1, A2, A3, Ai, Aj) comprises at least two subsections (UA1, UA2, UA3) which are electrically connected to one another in parallel; and
- each subsection (UA1, UA2, UA3) comprises a predetermined number of LEDs (3), preferably eleven LEDs, which are electrically connected to one another in series.

7. Flexible circuit board strip (1) according to Claim 6,
wherein the predetermined number of LEDs (3) of a respective subsection (UA1, UA2, UA3) is such that the forward voltage caused by the number of LEDs (3) corresponds to a SELV voltage.

8. Flexible circuit board strip (1) according to Claim 6 or 7,
- wherein each section (A1, A2, A3, Ai, Aj) comprises a predetermined number of subsections (UA1, UA2, UA3); and
- wherein the predetermined number of subsections (UA1, UA2, UA3) is such that the current required to operate the predetermined number of subsections (UA1, UA2, UA3) is less than a predetermined current, wherein the predetermined current is preferably between 14 mA and 500 mA, particularly preferably between 60 mA and 180 mA.

9. System comprising
- a flexible circuit board strip (1) according to any one of the preceding claims; and
- at least one contacting bridge (6) which comprises at least one contacting unit (7) and, by arrangement along the transverse extension of the flexible circuit board strip (1) perpendicular to and preferably above the flexible circuit board strip (1), is configured to electrically contact at least one contacting surface (a1, b1, a2, b2, a3, b3, ai, bi, aj, bj) of a section (A1, A2, A3, Ai, Aj) of the flexible circuit board strip (1) with the at least one contacting unit (7).
wherein the at least one contacting unit (7) preferably corresponds to an electrical spring contact.

10. System according to Claim 9, wherein the contacting bridge (6) comprises two contacting units (7) and is configured to electrically contact two contacting surfaces (a1, b1, a2, b2, a3, b3, ai, bi, aj, bj) of an electrical pair of contacts (4) of a section (A1, A2, A3, Ai, Aj) of the flexible circuit board strip (1) with said two contacting units (7).

11. System according to Claim 10,
- wherein the flexible circuit board strip (1) is divided into a first and second region by a center axis (MA) formed in longitudinal extension, and
- the two contacting units (7) of the contacting bridge (6) are disposed opposite one another on the contacting bridge (6) in longitudinal extension of the contacting bridge (6) such that the contacting bridge (6) is configured to contact two contacting surfaces (a1, b1, a2, b2, a3, b3, ai, bi, aj, bj) of an electrical pair of contacts (4) of a section (A1, A2, A3, Ai, Aj) of the flexible circuit board strip (1) with the two contacting units (7), wherein a first contacting surface (a1, a2, a3, ai, aj) of the at least two contacting surfaces (a1, b1, a2, b2, a3, b3, ai, bi, aj, bj) of the electrical pair of contacts (4) in the first region and a second contacting surface (a1, a2, a3, ai, aj) of the at least two contacting surfaces (a1, b1, a2, b2, a3, b3, ai, bi, aj, bj) of the electrical pair of contacts (4) in the second region of the flexible circuit board strip (1) are disposed opposite to one another.

12. Insert for a lamp (9), wherein the insert comprises
- at least one section (A1, A2, A3, Ai, Aj) of the flexible circuit board strip (1) according to Claims 1 to 8,
- at least one contacting bridge (6) as defined in Claims 9 to 11, and
- a carrier plate (10); wherein
- the at least one section (A1, A2, A3, Ai, Aj) is mounted on the carrier plate (10); and
- the two contacting surfaces (a1, b1, a2, b2, a3, b3, ai, bi, aj, bj) of the at least one electrical pair of contacts (4) of the at least one section (A1, A2, A3, Ai, Aj) are electrically contacted by the at least one contacting bridge (6) .

13. Insert for a lamp (9) according to Claim 12, wherein the carrier plate (10) is made of metal, preferably aluminum, and forms a heat sink.

14. Insert for a lamp (9) according to Claim 12 or 13, wherein the at least one section (A1, A2, A3, Ai, Aj) of the flexible circuit board strip (1) is mounted on the carrier plate (10) by means of an adhesive connection, preferably adhesive tape or liquid adhesive.

## Revendications

1. Bande de circuit imprimé flexible (1) comprenant :
- une ligne de DEL (2) présentant des DEL (3) reliées électriquement en série ; ladite ligne de DEL (2) présentant plusieurs DEL (3) disposées en rangée dans le sens de la longueur de ladite bande de circuit imprimé flexible (1), sur ladite bande de circuit imprimé flexible (1) ;
- ladite bande de circuit imprimé flexible (1) étant divisée en une pluralité de sections (A1, A2, A3, Ai, Aj), chaque section (A1, A2, A3, Ai, Aj) comprenant un nombre prédéterminé de DEL (3) ,
- chaque section (A1, A2, A3, Ai, Aj) comprenant au moins une paire de contacts électriques (4) présentant deux surfaces de contact (a1, b1, a2, b2, a3, b3, ai, bi, aj, bj) permettant le contact électrique des DEL (3) présentes dans la section (A1, A2, A3, Ai, Aj) respective ;
- lesdites deux surfaces de contact (a1, b1, a2, b2, a3, b3, ai, bi, aj, bj) de l'au moins une paire de contacts (4) étant disposées dans la section (A1, A2, A3, Ai, Aj) respective, sur la bande de circuit imprimé flexible (1), de telle manière que les deux surfaces de contact (a1, b1, a2, b2, a3, b3, ai, bi, aj, bj) peuvent être mises en contact électrique par au moins un pont de contact (6) disposé dans le sens transversal de la bande de circuit imprimé flexible (1), transversalement à la bande de circuit imprimé flexible (1) et de préférence par-dessus de celle-ci ;
ladite bande de circuit imprimé flexible étant **caractérisée en ce que** chaque section (A1, A2, A3, Ai, Aj) présente, dans le sens de la longueur de la bande de circuit imprimé flexible (1), deux zones marginales (RB) situées, dans le sens de la longueur de la bande de circuit imprimé flexible (1), sur des côtés opposés de la zone intérieure (IB) de la section respective (A1, A2, A3, Ai, Aj) formée dans le sens de la longueur de la bande de circuit imprimé flexible (1), et
**en ce que** chaque zone marginale (RB) présente au moins une surface de liaison (5) disposée, dans la zone marginale (RB) respective, sur la bande de circuit imprimé flexible (1), de telle manière que la surface de liaison (5) d'une zone marginale (RB) d'une section (A1, A2, A3, Ai, Aj) de la bande de circuit imprimé flexible (1) peut être reliée électriquement à la surface de liaison (5) d'une zone marginale (RB) d'une autre section (A1, A2, A3, Ai, Aj) de la bande de circuit imprimé flexible (1) par l'intermédiaire d'une carte de circuit imprimé de contact (8).

2. Bande de circuit imprimé flexible (1) selon la revendication 1,
- dans laquelle la bande de circuit imprimé flexible (1) est divisée en une première et une deuxième zone par un axe central (MA) formé dans le sens de la longueur, et
- dans chaque section (A1, A2, A3, Ai, Aj), l'au moins une paire de contacts électriques (4) est disposée dans la première ou la deuxième zone.

3. Bande de circuit imprimé flexible (1) selon la revendication 1,
- dans laquelle la bande de circuit imprimé flexible (1) est divisée en une première et une deuxième zone par un axe central (MA) formé dans le sens de la longueur, et
- dans laquelle, dans chaque section (A1, A2, A3, Ai, Aj), une première surface de contact (a1, a2, a3, ai, aj) des deux surfaces de contact (a1, b1, a2, b2, a3, b3, ai, bi, aj, bj) de l'au moins une paire de contacts électriques (4) est disposée dans la première zone, et une deuxième surface de contact (b1, b2, b3, bi, bj) des deux surfaces de contact (a1, b1, a2, b2, a3, b3, ai, bi, aj, bj) de l'au moins une paire de contacts électriques (4) est disposée dans la deuxième zone de telle manière que la première surface de contact (a1, a2, a3, ai, aj) et la deuxième surface de contact (b1, b2, b3, bi, bj) de l'au moins une paire de contacts électriques (4) sont disposées en vis-à-vis sur la bande de circuit imprimé flexible (1).

4. Bande de circuit imprimé flexible (1) selon l'une des revendications précédentes, dans laquelle, dans chaque section (A1, A2, A3, Ai, Aj), les deux surfaces de contact (a1, b1, a2, b2, a3, b3, ai, bi, aj, bj) de l'au moins une paire de contacts électriques (4) sont disposées dans une zone intérieure (IB, IB') de la section respective par rapport au sens de la longueur et/ou transversal de la bande de circuit imprimé flexible (1).

5. Bande de circuit imprimé flexible (1) selon l'une des revendications précédentes,
- dans laquelle chaque section (A1, A2, A3, Ai, Aj) est apte à être retirée de la bande de circuit imprimé flexible (1) de telle manière que les DEL (3) de la section respective (A1, A2, A3, Ai, Aj) puissent assurer une fonction électrique.

6. Bande de circuit imprimé flexible (1) selon l'une des revendications précédentes,
- dans laquelle chaque section (A1, A2, A3, Ai, Aj) comprend au moins deux sous-sections (UA1, UA2, UA3) reliées électriquement entre elles en parallèle, et
- chaque sous-section (UA1, UA2, UA3) présente un nombre prédéterminé de DEL (3), de préférence onze, reliées électriquement les unes aux autres en série.

7. Bande de circuit imprimé flexible (1) selon la revendication 6,
dans laquelle le nombre prédéterminé de DEL (3) d'une sous-section (UA1, UA2, UA3) respective est tel que la tension à l'état passant provoquée par le nombre de DEL (3) correspond à une tension SELV.

8. Bande de circuit imprimé flexible (1) selon la revendication 6 ou 7,
- dans laquelle chaque section (A1, A2, A3, Ai, Aj) comprend un nombre prédéterminé de sous-sections (UA1, UA2, UA3), et
- dans laquelle le nombre prédéterminé de sous-sections (UA1, UA2, UA3) est tel que l'intensité nécessaire pour faire fonctionner le nombre prédéterminé de sous-sections (UA1, UA2, UA3) est inférieure à une intensité prédéterminée, l'intensité prédéterminée étant de préférence comprise entre 14 mA et 500 mA et plus préférablement entre 60 mA et 180 mA.

9. Système comprenant :
- une bande de circuit imprimé flexible (1) selon l'une des revendications précédentes, et
- au moins un pont de contact (6) présentant au moins une unité de contact (7) et qui, grâce à une disposition dans le sens transversal de la bande de circuit imprimé flexible (1), transversalement à la bande de circuit imprimé flexible (1) et de préférence au-dessus de celle-ci, est apte à venir en contact électrique avec au moins une surface de contact (a1, b1, a2, b2, a3, b3, ai, bi, aj, bj) d'une section (A1, A2, A3, Ai, Aj) de la bande de circuit imprimé flexible (1) par l'intermédiaire de ladite unité de contact (7) ;
ladite au moins une unité de contact (7) correspondant de préférence à un contact électrique à ressort.

10. Système selon la revendication 9, dans lequel le pont de contact (6) présente deux unités de contact (7) et, par le biais des deux unités de contact (7), est apte à venir en contact électrique avec deux surfaces de contact (a1, b1, a2, b2, a3, b3, ai, bi, aj, bj) d'une paire de contacts électriques (4) d'une section (A1, A2, A3, Ai, Aj) de la bande de circuit imprimé flexible (1).

11. Système selon la revendication 10,
- dans lequel la bande de circuit imprimé flexible (1) est divisée en une première et une deuxième zone par un axe central (MA) formé dans le sens de la longueur, et
- les deux unités de contact (7) du pont de contact (6) sont disposées en vis-à-vis sur le pont de contact (6), dans le sens de la longueur du pont de contact (6), de telle manière que le pont de contact (6) est apte à venir en contact électrique avec deux surfaces de contact (a1, b1, a2, b2, a3, b3, ai, bi, aj, bj) d'une paire de contacts électriques (4) d'une section (A1, A2, A3, Ai, Aj) de la bande de circuit imprimé flexible (1) par le biais des deux unités de contact (7), étant entendu qu'une première surface de contact (a1, a2, a3, ai, aj) des au moins deux surfaces de contact (a1, b1, a2, b2, a3, b3, ai, bi, aj, bj) de la paire de contacts électriques (4) située dans la première zone et que la deuxième surface de contact (a1, a2, a3, ai, aj) des au moins deux surfaces de contact (a1, b1, a2, b2, a3, b3, ai, bi, aj, bj) de la paire de contacts électriques (4) située dans la deuxième zone de la bande de circuit imprimé flexible (1) sont disposées en vis-à-vis.

12. Insert destiné à une lampe (9), l'insert présentant :
- au moins une section (A1, A2, A3, Ai, Aj) de la bande de circuit imprimé flexible (1) selon les revendications 1 à 8,
- au moins un pont de contact (6) tel que défini dans les revendications 9 à 11, et
- une plaque de support (10) ; étant entendu que
- au moins une section (A1, A2, A3, Ai, Aj) est montée sur ladite plaque de support (10), et
- les deux surfaces de contact (a1, b1, a2, b2, a3, b3, ai, bi, aj, bj) de l'au moins une paire de contacts électriques (4) de l'au moins une section (A1, A2, A3, Ai, Aj) sont mises en contact électrique par l'au moins un pont de contact (6).

13. Insert destiné à une lampe (9) selon la revendication 12, dans lequel la plaque de support (10) est en métal, de préférence en aluminium, et constitue un dissipateur de chaleur.

14. Insert destiné à une lampe (9) selon la revendication 12 ou 13, dans lequel l'au moins une section (A1, A2, A3, Ai, Aj) de la bande de circuit imprimé flexible (1) est montée sur la plaque de support (10) par le biais d'une liaison adhésive, de préférence d'un ruban adhésif ou d'un adhésif liquide.
